# EUROPEAN PATENT APPLICATION

(11) **EP 4 598 284 A1**
(43) Date of publication of application: **06.08.2025**
(21) Application number: 25155229.5
(22) Date of filing: 31.01.2025
(51) Int. Cl.: H05K 1/14, H05K 1/02, H05K 3/40, G03B 17/00, H05K 1/18, H05K 3/36

(54) **ELECTRONIC MODULE AND ELECTRONIC APPARATUS**

(30) Priority: 02.02.2024 JP 2024014964
(71) Applicant: CANON KABUSHIKI KAISHA, Tokyo 146-8501 (JP)
(72) Inventor: KIKUCHI, Masanori, Ohta-ku, Tokyo, 146-8501 (JP); ITO, Shingo, Ohta-ku, Tokyo, 146-8501 (JP); UMEGAE, Momoka, Ohta-ku, Tokyo, 146-8501 (JP)
(74) Representative: TBK

(57) **Abstract**

An electronic module includes a first wiring board (11), a first semiconductor device (21), a second wiring board (12) configured to overlap with the first wiring board in a first direction (Z) orthogonal to a main surface (111) of the first wiring board, a second semiconductor device (22), and a wiring member (31). A first wiring terminal (3111) and a second wiring terminal (3112) of the wiring member are disposed between a first imaginary plane (V1) and a second imaginary plane (V2), the first imaginary plane being orthogonal to the main surface and configured to cross the first signal terminal, the second imaginary plane being parallel to the first imaginary plane and configured to cross the second signal terminal, and/or a first signal terminal (2111) and a second signal terminal (2112) of the first semiconductor device are configured not to overlap with the wiring member in the first direction.

## Description

### BACKGROUND OF THE INVENTION

### Field of the Invention

The present disclosure relates to an electronic module and an electronic apparatus.

### Description of the Related Art

An electronic apparatus, such as a digital camera, a smartphone, or a mobile PC, includes an electronic module that includes a plurality of semiconductor devices. The electronic module has a three-dimensional mounting structure in which two wiring boards are laminated to each other, for reducing the mounting area.

For example, Japanese Patent Application Publication No. 2012-8695 discloses a configuration in which a plurality of memory modules is mounted on a module socket. Each of the plurality of memory modules includes a module board and a plurality of memories mounted on the module board. The plurality of memories is disposed in four corners of the module board, and a center portion of the module board in which the memories are not disposed is connected to the module socket.

Japanese Patent Application Publication No. 2007-287820 discloses a semiconductor module that includes two wiring boards, a frame body disposed between the two wiring boards, and semiconductor devices disposed in a hollow portion formed by the two wiring boards and the frame body. That is, the frame body is disposed so as to surround the perimeter of the semiconductor devices disposed in the hollow portion.

Japanese Patent Application Publication No. 2022-19542 discloses an electronic module that includes two wiring boards, a plurality of intermediate connection members disposed between the two wiring boards, and semiconductor elements mounted on corresponding wiring boards. WO 2013/153717 discloses an electronic apparatus in which a connection support portion and a second electronic component are disposed between a board and a first electronic component. The connection support portion electrically connects the board and the first electronic component, and supports the first electronic component on the board. The second electronic component is mounted on the board.

In recent years, the operating speed of semiconductor devices has been increased remarkably. However, if the transmission property of a signal transmitted through a signal wiring is insufficient, it is not possible to increase the transmission speed of the signal. In this case, it is necessary to limit the operating speed of a semiconductor device in accordance with the possible transmission speed of the signal. Thus, it is required that the transmission property of a signal transmitted through a signal wiring be increased for effectively using the performance of the semiconductor device.

### SUMMARY OF THE INVENTION

The present invention in its first aspect provides an electronic module as specified in claims 1 to 20.

The present invention in its second aspect provides an electronic apparatus as specified in claim 21.

Further features of the present disclosure will become apparent from the following description of exemplary embodiments with reference to the attached drawings.

### BRIEF DESCRIPTION OF THE DRAWINGS

FIG. 1 is a schematic cross-sectional view of a camera that is an image pickup apparatus that serves as one example of an electronic apparatus of a first embodiment.
FIG. 2 is a diagram illustrating an image processing module of the first embodiment.
FIG. 3A is a plan view illustrating a relationship in arrangement between a memory, a wiring board, and a wiring member of the image processing module of the first embodiment.
FIG. 3B is a plan view illustrating a relationship in arrangement between an image processing engine, the memory, the wiring board, and the wiring member of the first embodiment.
FIG. 4A is a plan view illustrating a relationship in arrangement between the memory and the wiring member of the first embodiment.
FIG. 4B is a plan view illustrating a relationship in arrangement between the memory and the wiring member of the first embodiment.
FIG. 5A is a diagram illustrating a positional relationship between the memory, the wiring board, and the wiring member of the first embodiment.
FIG. 5B is a diagram illustrating a positional relationship between the memory, the wiring board, and the wiring member of the first embodiment.
FIG. 6A is a diagram illustrating a distance between two terminals of the first embodiment.
FIG. 6B is a diagram illustrating a wiring length between two terminals of the first embodiment.
FIG. 7 is a graph illustrating transmission property of signals in a signal wiring in the first embodiment, a signal wiring in Comparative Example 1, and a signal wiring in Comparative Example 2.
FIG. 8 is a plan view illustrating a relationship in arrangement between an image processing engine, a memory, a wiring board, and a wiring member of an image processing module of a second embodiment.
FIG. 9A is a plan view illustrating a relationship in arrangement between the memory, the wiring board, and the wiring member of the image processing module of the second embodiment.
FIG. 9B is a diagram illustrating a positional relationship between the memory, the wiring board, and the wiring member of the image processing module of the second embodiment.
FIG. 10 is a diagram illustrating an image processing module that is one example of an electronic module of a third embodiment.
FIG. 11 is a diagram illustrating an image processing module that is one example of an electronic module of a fourth embodiment.
FIG. 12A is a plan view illustrating a relationship in arrangement between a memory, a wiring board, and a wiring member of the image processing module of the fourth embodiment.
FIG. 12B is a plan view illustrating a relationship in arrangement between an image processing engine, the memory, the wiring board, and the wiring member of the fourth embodiment.
FIG. 13A is a plan view illustrating a relationship in arrangement between the memory and the wiring member of the fourth embodiment.
FIG. 13B is a plan view illustrating a relationship in arrangement between the memory and the wiring member of the fourth embodiment.
FIG. 14 is a diagram illustrating an image processing module that is one example of an electronic module of a fifth embodiment.
FIG. 15A is a diagram illustrating an image processing module of Comparative Example 1.
FIG. 15B is a diagram illustrating the image processing module of Comparative Example 1.
FIG. 16A is a diagram illustrating an image processing module of Comparative Example 2.
FIG. 16B is a diagram illustrating the image processing module of Comparative Example 2.
FIG. 17A is a diagram illustrating the wiring member of the first embodiment.
FIG. 17B is a diagram illustrating a wiring member of a modification.

### DESCRIPTION OF THE EMBODIMENTS

Hereinafter, example embodiments of the present disclosure will be described in detail with reference to the accompanying drawings. Note that in each drawing, an identical component is given an identical reference numeral, and the duplicate description thereof will be omitted. In the following description, a direction is expressed with respect to an XYZ coordinate system, which is an orthogonal coordinate system. The X axis, the Y axis, and the Z axis are orthogonal to each other. For example, the positive direction of the Z axis is the optical-axis direction.

### First Embodiment

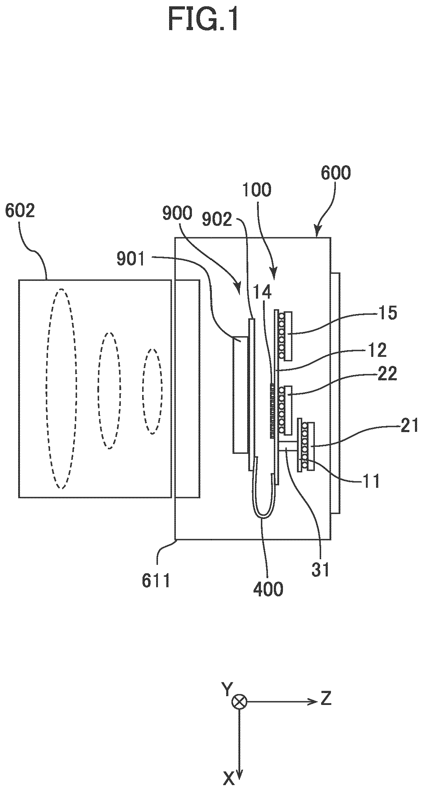

FIG. 1 is a schematic cross-sectional view of a camera 600 that is an image pickup apparatus that serves as one example of an electronic apparatus of a first embodiment. The camera 600 is a digital camera with an interchangeable lens, and a lens unit (lens barrel) 602 that includes lenses is detachably attached to the camera 600. The camera 600 includes an exterior 611, an image processing module 100, and a sensor module 900. The image processing module 100 and the sensor module 900 are disposed inside the exterior 611. Each of the image processing module 100 and the sensor module 900 is an electronic module that includes a printed circuit board. The image processing module 100 and the sensor module 900 are electrically connected with each other via a flexible printed wiring board 400. In addition, a battery (not illustrated) is disposed inside the exterior 611.

The sensor module 900 includes an image sensor 901 and a printed wiring board 902. The image sensor 901 is mounted on the printed wiring board 902. The image sensor 901 is, for example, a complementary metal oxide semiconductor (CMOS) image sensor or a charge coupled device (CCD) image sensor. The image sensor 901 has a function that converts the light, having passed through the lens unit 602, to an electrical signal.

The image processing module 100 includes an image processing engine 22, a memory 21, a power supply circuit 15, and a plurality of capacitors 14. The image processing engine 22 is an image processing device, such as a digital signal processor; and has a function to receive an electrical signal from the image sensor 901, correct the electrical signal received, and create image data. The memory 21 is, for example, a memory device such as a DRAM or a flash memory. The DRAM may be a DDR5 (DDR: double data rate). The image processing engine 22 functions also as a memory controller that controls the memory 21. The image processing engine 22 can store image data in the memory 21 and read the image data stored in the memory 21.

Each of the image processing engine 22 and the memory 21 is a semiconductor device. The memory 21 is one example of a first semiconductor device, and the image processing engine 22 is one example of a second semiconductor device. Each of the image processing engine 22 and the memory 21 is a semiconductor package that includes a semiconductor integrated circuit, and the semiconductor package may be a type of a ball grid array (BGA) or a land grid array (LGA). Note that the semiconductor package is preferably any one of the above-described types, but is not limited to the types. For example, the semiconductor package may be any type of semiconductor packages, such as a quad flat package (QFP), a quad flat non-leaded package (QFN), a quad flat J-leaded package (QFJ), or a chip size package (CSP).

The power supply circuit 15 supplies electric power from the battery (not illustrated) to each of the image processing engine 22 and the memory 21, via a feed line that includes a power supply line and a ground line of the image processing module 100.

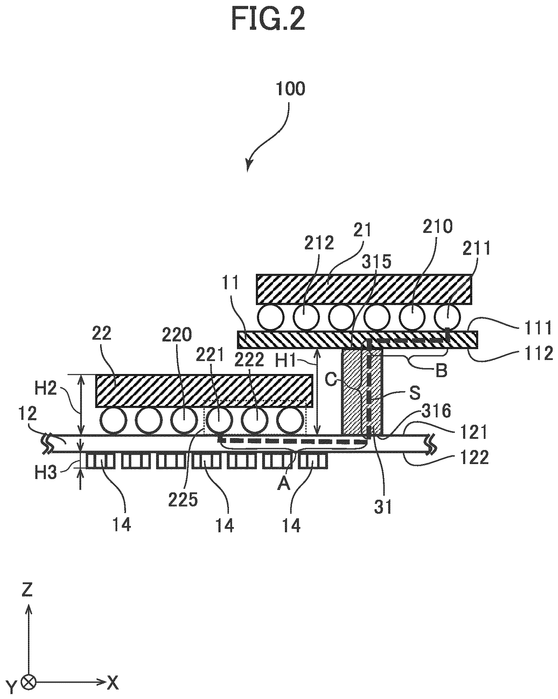

FIG. 2 is a diagram illustrating the image processing module 100 of the first embodiment. FIG. 2 schematically illustrates a cross section of the image processing module 100, taken along an XZ plane.

The image processing engine 22 includes a plurality of terminals 220 arranged in a matrix and spaced from each other in a direction along an XY plane. The plurality of terminals 220 of the image processing engine 22 includes a plurality of signal terminals 221 and a plurality of feed terminals 222. Each of the feed terminals 222 is a power supply terminal or a ground terminal.

The memory 21 includes a plurality of terminals 210 arranged in a matrix and spaced from each other in a direction along an XY plane. The plurality of terminals 210 of the memory 21 includes a plurality of signal terminals 211 and a plurality of feed terminals 212. Each of the feed terminals 212 is a power supply terminal or a ground terminal.

Each of the capacitors 14 is a bypass capacitor for stabilizing the power supply voltage supplied to the image processing engine 22, and is disposed between a power supply terminal and a ground terminal of the image processing engine 22.

The image processing module 100 includes a wiring board 11, that is a memory board (sub-board), and a wiring board 12 that is a main board. The wiring board 11 is one example of a first wiring board, and the wiring board 12 is one example of a second wiring board. Each of the wiring boards 11 and 12 is a rigid printed wiring board. The wiring board 11 is a board on which the memory 21 is mounted, and the wiring board 12 is a board on which the image processing engine 22 and the capacitors 14 are mounted. Note that the power supply circuit 15 illustrated in FIG. 1 may be mounted on the wiring board 12.

The wiring board 11 includes a main surface 111, that is a mounting surface, and a main surface 112 that is a mounting surface. The main surface 112 is a main surface opposite to the main surface 111. The main surface 111 is one example of a first main surface, and the main surface 112 is one example of a second main surface.

The wiring board 12 includes a main surface 121, that is a mounting surface, and a main surface 122 that is a mounting surface. The main surface 122 is a main surface opposite to the main surface 121. The main surface 121 is one example of a third main surface, and the main surface 122 is one example of a fourth main surface.

In the first embodiment, a direction orthogonal to the main surface 111 is a Z direction. The Z direction includes the positive direction of the Z axis and the negative direction of the Z axis. The wiring board 11 and the wiring board 12 are disposed, spaced from each other in the Z direction. In the Z direction, the main surface 112 of the wiring board 11 faces the main surface 121 of the wiring board 12. The Z direction is one example of a first direction. An X direction and a Y direction are directions orthogonal to the Z direction. The Y direction is a direction orthogonal to the X direction. The X direction is one example of a second direction, and the Y direction is one example of a third direction.

The main surfaces 111, 112, 121, and 122 are substantially parallel with each other. Thus, the direction orthogonal to the main surface 111 of the wiring board 11 is substantially the same as the direction orthogonal to the main surface 112 of the wiring board 11, the direction orthogonal to the main surface 121 of the wiring board 12, and the direction orthogonal to the main surface 122 of the wiring board 12. The Z direction serves also as a direction in which the image processing module 100 is viewed in a plan view. In addition, if an object is viewed in the Z direction, that is, the object is viewed in a plan view, the object is seen through in the Z direction. In addition, the expression of "in the Z direction" can include the expression of "when viewed in the Z direction".

In the Z direction, the wiring board 11 overlaps with the wiring board 12. In other words, in the Z direction, the wiring board 12 overlaps with the wiring board 11.

In the first embodiment, in the Z direction, the size of the wiring board 11 is smaller than the size of the wiring board 12. In addition, in the Z direction, at least one portion of the wiring board 11 overlaps with one portion of the wiring board 12. In the first embodiment, in the Z direction, the whole of the wiring board 11 overlaps with one portion of the wiring board 12. In other words, in the Z direction, one portion of the wiring board 12 overlaps with the whole of the wiring board 11.

The memory 21 is mounted on the main surface 111 of the wiring board 11. The image processing engine 22 is mounted on the main surface 121 of the wiring board 12. The plurality of capacitors 14 is mounted on the main surface 122 of the wiring board 12. Preferably, each of the capacitors 14 is disposed closer to the image processing engine 22. In the first embodiment, in the Z direction, each of the capacitors 14 overlaps with the image processing engine 22. Note that the plurality of capacitors 14 may include a capacitor 14 that does not overlap with the image processing engine 22 in the Z direction. In addition, in the Z direction, some of the plurality of capacitors 14 overlap with the wiring board 11. In addition, in the Z direction, some of the plurality of capacitors 14 overlap with the memory 21.

In the first embodiment, the memory 21 is surface-mounted on the main surface 111 of the wiring board 11. The image processing engine 22 is surface-mounted on the main surface 121 of the wiring board 12. The capacitors 14 are chip components and are surface-mounted on the main surface 122 of the wiring board 12.

The image processing module 100 includes a wiring member 31 that is disposed between the wiring board 11 and the wiring board 12, and that electrically and mechanically connects the wiring board 11 and the wiring board 12. Specifically, the wiring member 31 is disposed between the main surface 112 of the wiring board 11 and the main surface 121 of the wiring board 12, and electrically and mechanically connects the main surface 112 of the wiring board 11 and the main surface 121 of the wiring board 12.

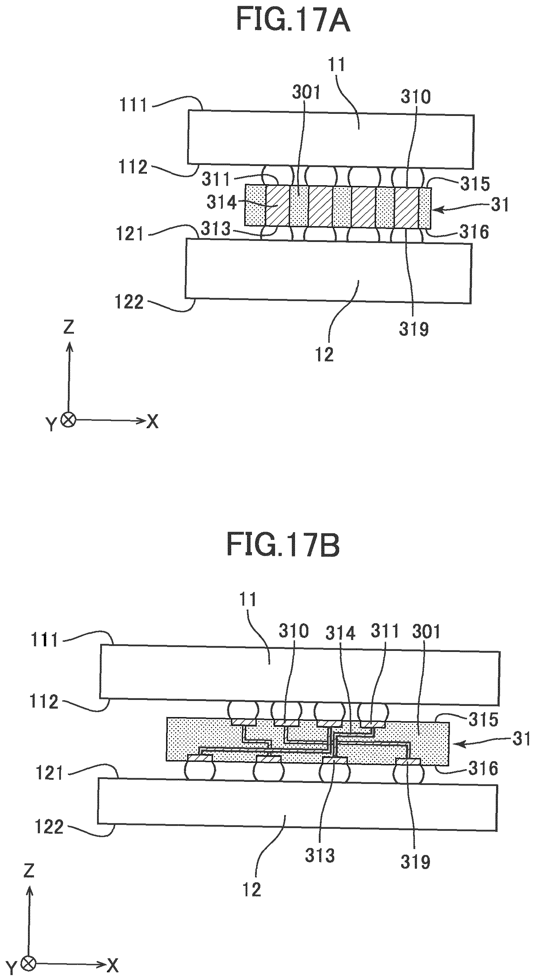

FIG. 17A is a diagram illustrating the wiring member 31 of the first embodiment. FIG. 17A schematically illustrates a cross section of the wiring member 31, and schematically illustrates the wiring board 11 and the wiring board 12 that are connected to the wiring member 31 via solder. The wiring member 31 includes a joining surface 315, that is a first joining surface (mounting surface), and a joining surface 316 that is a second joining surface (mounting surface) opposite to the joining surface 315. The joining surface 315 of the wiring member 31 is electrically and mechanically connected to the main surface 112 of the wiring board 11 via a plurality of joining members, and the joining surface 316 of the wiring member 31 is electrically and mechanically connected to the main surface 121 of the wiring board 12 via a plurality of joining members. For example, each of the joining members is solder. The wiring member 31 functions also as a spacer between the wiring board 11 and the wiring board 12. In the first embodiment, the wiring member 31 is a rigid wiring board. The wiring member 31 is one example of a first wiring member.

As illustrated in FIG. 2, a distance H1 between the main surface 112 of the wiring board 11 and the main surface 121 of the wiring board 12 in the Z direction is larger than a height H2 of the image processing engine 22 in the Z direction. In addition, the wiring member 31 and the image processing engine 22 are disposed adjacent to each other in the X direction. That is, in the Z direction, the image processing engine 22 overlaps with the wiring board 11. Note that a height H3 of the capacitors 14 in the Z direction is smaller than the height H2 of the image processing engine 22 in the Z direction.

The plurality of terminals 210 of the memory 21 includes a plurality of signal terminals 211. In FIG. 2, one of the plurality of signal terminals 211 is given a symbol. The plurality of terminals 220 of the image processing engine 22 includes a plurality of signal terminals 221. In FIG. 2, one of the plurality of signal terminals 221 is given a symbol. The plurality of signal terminals 211 is electrically connected to the plurality of corresponding signal terminals 221 via a plurality of signal wirings S. In FIG. 2, one of the plurality of signal wirings S is illustrated. The signal wiring S illustrated in FIG. 2 has the longest wiring length in the plurality of signal wirings S. The plurality of signal wirings S can be used for data transmission between the image processing engine 22 and the memory 21. That is, digital signals are transmitted through each of the plurality of signal wirings S.

Each of the signal wirings S is disposed so as to extend in the wiring board 11, the wiring member 31, and the wiring board 12. That is, each of the signal wirings S includes a conductor included in the wiring board 11, a conductor included in the wiring member 31, and a conductor included in the wiring board 12. That is, the wiring path of each of the signal wirings S from the memory 21 to the image processing engine 22 extends through the wiring member 31.

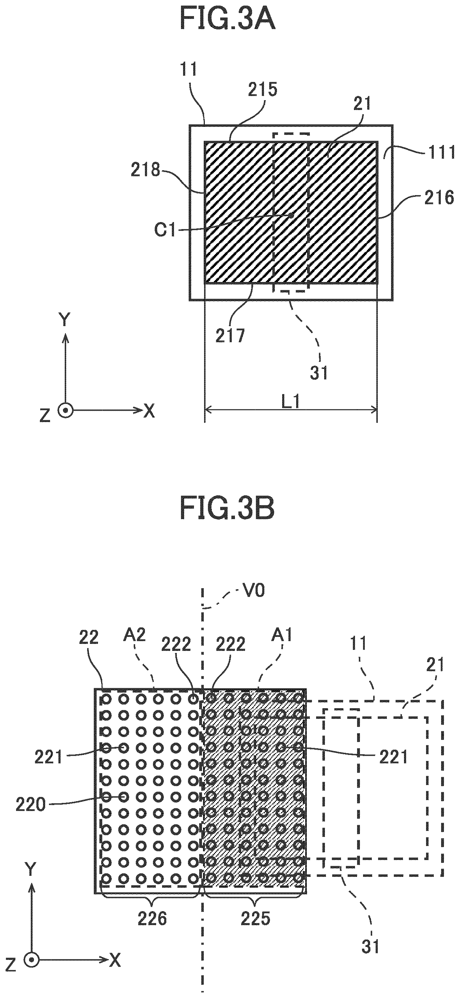

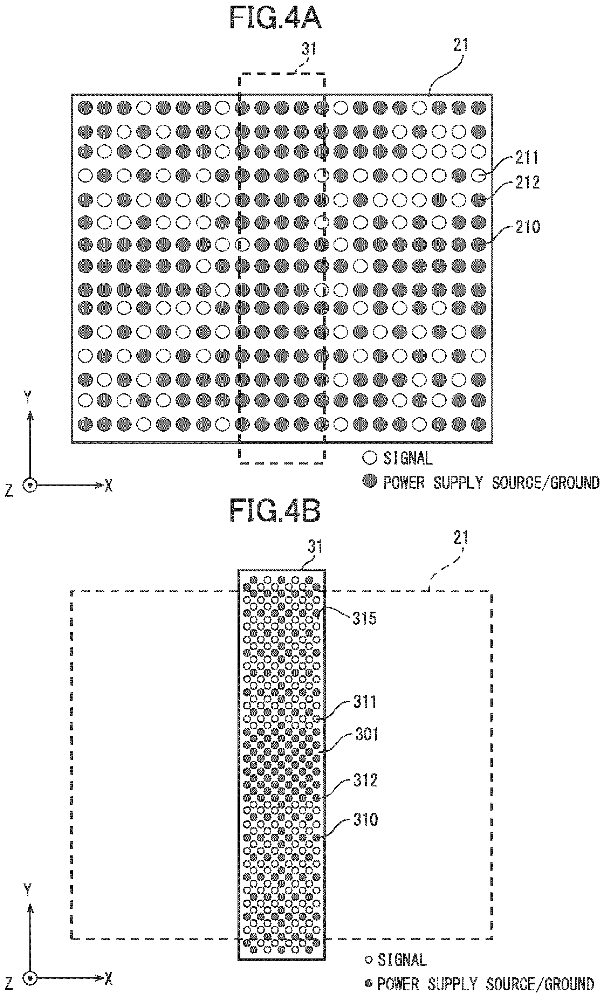

FIG. 3A is a plan view illustrating a relationship in arrangement between the memory 21, the wiring board 11, and the wiring member 31 of the image processing module 100 of the first embodiment. FIG. 3B is a plan view illustrating a relationship in arrangement between the image processing engine 22, the memory 21, the wiring board 11, and the wiring member 31 of the first embodiment. Each of FIGS. 4A and 4B is a plan view illustrating a relationship in arrangement between the memory 21 and the wiring member 31 of the first embodiment. Note that in FIG. 4B, the joining surface 315 of the wiring member 31 is illustrated.

As illustrated in FIG. 3A, in the Z direction (when viewed in the Z direction), each of the wiring board 11 and the memory 21 has a rectangular shape, and the size of the wiring board 11 is equal to or larger than the size of the memory 21. When viewed in the Z direction, the memory 21 may have a square shape. In the first embodiment, the memory 21 has a rectangular shape. In addition, when viewed in the Z direction, the four corner portions of the memory 21 may be sharp, R-chamfered, or C-chamfered.

In the first embodiment, the longitudinal direction of the memory 21 is the X direction, and the lateral direction of the memory 21 is the Y direction. Note that the longitudinal direction of the memory 21 may be the Y direction, and the lateral direction of the memory 21 may be the X direction.

In the Z direction, the wiring member 31 overlaps with a center C1 of the memory 21. When viewed in the Z direction, the center C1 is a point at which two diagonal lines of the memory 21 cross each other. In addition, as illustrated in FIG. 3A, when viewed in the Z direction, the wiring member 31 has a rectangular shape, and the size of the wiring member 31 is smaller than the size of the wiring board 11. In addition, in the Z direction, the whole of the wiring member 31 overlaps with one portion of the wiring board 11.

When viewed in the Z direction, the outer shape of the memory 21 is rectangular. Thus, the memory 21 has four sides 215, 216, 217, and 218. The opposite two sides 215 and 217 of the four sides 215 to 218 are long sides, and the opposite two sides 216 and 218 are short sides. That is, each of the sides 215 and 217 is longest of the sides included in the memory 21. Each of the sides 215 and 217 extends in the X direction, and each of the sides 216 and 218 extends in the Y direction. That is, the sides 215 and 217 are parallel to each other, and the sides 216 and 218 are parallel to each other. The sides 216 and 218 are orthogonal to the sides 215 and 217.

The wiring member 31 is formed like a rectangular parallelopiped or a flat plate. As illustrated in FIGS. 4B and 17A, the wiring member 31 includes a plurality of terminals 310 disposed in the joining surface 315, and a plurality of terminals 319 disposed in the joining surface 316. The wiring member 31 includes an insulating board 301. The insulating board 301 is a rigid insulating board formed like a rectangular parallelopiped or a flat plate. The insulating board 301 has a plurality of through-holes that pass through the insulating board 301 in the Z direction. In each of the plurality of through-holes, a via conductor is disposed for connecting a corresponding terminal 310 of the plurality of terminals 310 and a corresponding terminal 319 of the plurality of terminals 319. Each of the plurality of via conductors is disposed in a corresponding through-hole so as to extend from a first end surface to a second end surface of the insulating board 301 in the Z direction.

As illustrated in FIG. 4B, in the Z direction (when viewed in the Z direction), the wiring member 31 has a rectangular shape. When viewed in the Z direction, the wiring member 31 may have a square shape. In the first embodiment, the wiring member 31 has a rectangular shape. In addition, when viewed in the Z direction, the four corner portions of the wiring member 31 may be sharp, R-chamfered, or C-chamfered. In the first embodiment, the longitudinal direction of the wiring member 31 is the Y direction, and the lateral direction of the wiring member 31 is the X direction.

Note that in FIG. 3B, the plurality of terminals 220 of the image processing engine 22 is schematically illustrated with solid lines. In addition, in FIG. 4A, the plurality of terminals 210 of the memory 21 is schematically illustrated with solid lines. In addition, in FIG. 4B, the plurality of terminals 310 of the wiring member 31 is schematically illustrated with solid lines.

As illustrated in FIG. 4A, the plurality of terminals 210 of the memory 21 is arranged in a matrix and spaced from each other in a direction along an XY plane. The plurality of terminals 210 includes the plurality of signal terminals 211 and the plurality of feed terminals 212. Each of the feed terminals 212 is a power supply terminal or a ground terminal. Each of the signal terminals 211 is a terminal for inputting or outputting a signal. Each of the feed terminals 212 is a terminal to which a voltage (i.e., a power supply potential or a ground potential) necessary for operating the memory 21 is applied. Note that in FIG. 4A, a white circle represents a signal terminal 211 and a gray circle represents a feed terminal 212.

As illustrated in FIG. 4B, the plurality of terminals 310 of the wiring member 31 is arranged in a matrix and spaced from each other in a direction along an XY plane. Although not illustrated, the plurality of terminals 319 is arranged in a matrix and spaced from each other in a direction along an XY plane. The plurality of terminals 310 includes a plurality of wiring terminals 311 and a plurality of wiring terminals 312. Each of the wiring terminals 311 is used as one portion of a signal wiring S. Each of the wiring terminals 312 is used as one portion of a power supply wiring or a ground wiring, which is used for supplying electric power to the memory 21. Note that in FIG. 4B, a white circle represents a wiring terminal 311 and a gray circle represents a wiring terminal 312.

In addition, as illustrated in FIG. 17A, the plurality of terminals 319 includes a plurality of wiring terminals 313. Each of the wiring terminals 313 is used as one portion of a signal wiring S.

As illustrated in FIG. 3B, the plurality of terminals 220 of the image processing engine 22 is arranged in a matrix and spaced from each other in a direction along an XY plane. The plurality of terminals 220 includes the plurality of signal terminals 221 and the plurality of feed terminals 222. Each of the feed terminals 222 is a power supply terminal or a ground terminal. Each of the signal terminals 221 is a terminal for inputting or outputting a signal. Each of the feed terminals 222 is a terminal to which a voltage (i.e., a power supply potential or a ground potential) necessary for operating the image processing engine 22 is applied.

As illustrated in FIG. 3B, when viewed in the Z direction, the size of the image processing engine 22 is equal to or larger than the size of the memory 21.

In addition, as illustrated in FIG. 3B, the plurality of terminals 220 of the image processing engine 22 is equally divided into two areas A1 and A2. As an example, an imaginary plane V0 is defined. When viewed in the Z direction, the imaginary plane V0 passes through a center point of each of two sides of the rectangular image processing engine 22 that are opposite to each other, and that extend in the X direction. The imaginary plane V0 is orthogonal to the two sides. The imaginary plane V0 is a YZ plane, for example. That is, the imaginary plane V0 is an imaginary plane orthogonal to the main surface 111 of the wiring board 11. The area A1 is defined as an area that is closer to the wiring member 31 than the imaginary plane V0 is, and the area A2 is defined as an area that is separated more from the wiring member 31 than the imaginary plane V0 is. The area A1 includes a terminal group 225 that includes four or more terminals 220 of the plurality of terminals 220. The area A2 includes a terminal group 226 that includes four or more terminals 220 of the plurality of terminals 220.

The terminal group 225 includes two or more signal terminals 221 and two or more feed terminals 222. The terminal group 226 includes two or more signal terminals 221 and two or more feed terminals 222. Each of the signal terminals 211 of the memory 21 is electrically connected to a corresponding signal terminal 221 of the signal terminals 221 included in the terminal group 225, via a signal wiring S.

In this manner, the plurality of signal terminals 211 of the memory 21 is electrically connected to the image processing engine 22 via the plurality of corresponding wiring terminals 311 of the wiring member 31.

The memory 21 and the wiring board 11 are joined with each other by using solder. In addition, the image processing engine 22 and the wiring board 12 are joined with each other by using solder. In addition, the wiring member 31 and the wiring board 11 are joined with each other by using solder, and the wiring member 31 and the wiring board 12 are joined with each other by using solder.

Each of the plurality of terminals 210 of the memory 21 includes a pad (or a land). Each of the plurality of terminals 220 of the image processing engine 22 includes a pad (or a land). Each of the plurality of terminals 310 of the joining surface 315 of the wiring member 31 includes a pad (or a land). Each of the plurality of terminals 319 of the joining surface 316 of the wiring member 31 includes a pad (or a land).

The plurality of terminals 210 included in the memory 21 and the plurality of pads included in the main surface 111 of the wiring board 11 are respectively joined with each other via solder. In addition, the plurality of terminals 220 included in the image processing engine 22 and the plurality of pads included in the main surface 121 of the wiring board 12 are respectively joined with each other via solder.

In addition, the plurality of pads included in the main surface 112 of the wiring board 11 and the plurality of terminals 310 of the wiring member 31 are respectively joined with each other via solder. In addition, the plurality of pads included in the main surface 121 of the wiring board 12 and the plurality of terminals 319 of the wiring member 31 are respectively joined with each other via solder.

In addition, two electrodes of each of the plurality of capacitors 14 and two pads included in the main surface 122 of the wiring board 12 are respectively joined with each other via solder.

As illustrated in FIG. 17A, the wiring member 31 includes the plurality of wiring terminals 311 included in the joining surface 315, the plurality of wiring terminals 313 included in the joining surface 316, and a plurality of wirings 314 that connect the plurality of wiring terminals 311 and the plurality of corresponding wiring terminals 313. The plurality of wiring terminals 311 constitute a first wiring-terminal group, the plurality of wiring terminals 313 constitute a second wiring-terminal group, and the plurality of wirings 314 constitute a wiring group. Each of the plurality of wirings 314 is connected to the wiring board 11 via a corresponding wiring terminal 311 of the plurality of wiring terminals 311. In addition, each of the plurality of wirings 314 is connected to the wiring board 12 via a corresponding wiring terminal 313 of the plurality of wiring terminals 313.

Note that a plurality of wiring terminals described in the claims may be one of the plurality of wiring terminals 311 of the first wiring-terminal group and the plurality of wiring terminals 313 of the second wiring-terminal group. In the first embodiment, the plurality of wiring terminals is the plurality of wiring terminals 311.

Preferably, each of the wirings 314 is a conductor disposed in the through-hole, as described above, for easily making the wiring member 31. However, the structure of the wirings 314 is not limited to the above-described structure. FIG. 17B is a diagram illustrating a wiring member 31 of a modification. In FIG. 17B, a cross section of the wiring member 31 of the modification is schematically illustrated. In addition, a wiring board 11 and a wiring board 12 that are joined with the wiring member 31 via solder are schematically illustrated. Hereinafter, the wiring member 31 of the modification will be described.

As illustrated in FIG. 17B, each of the wirings 314 of the wiring group may include one or more via conductors, and one or more conductor patterns included in an inner-layer wiring layer. In addition, as illustrated in FIG. 17B, each of the wirings 314 may have a complicated connection structure.

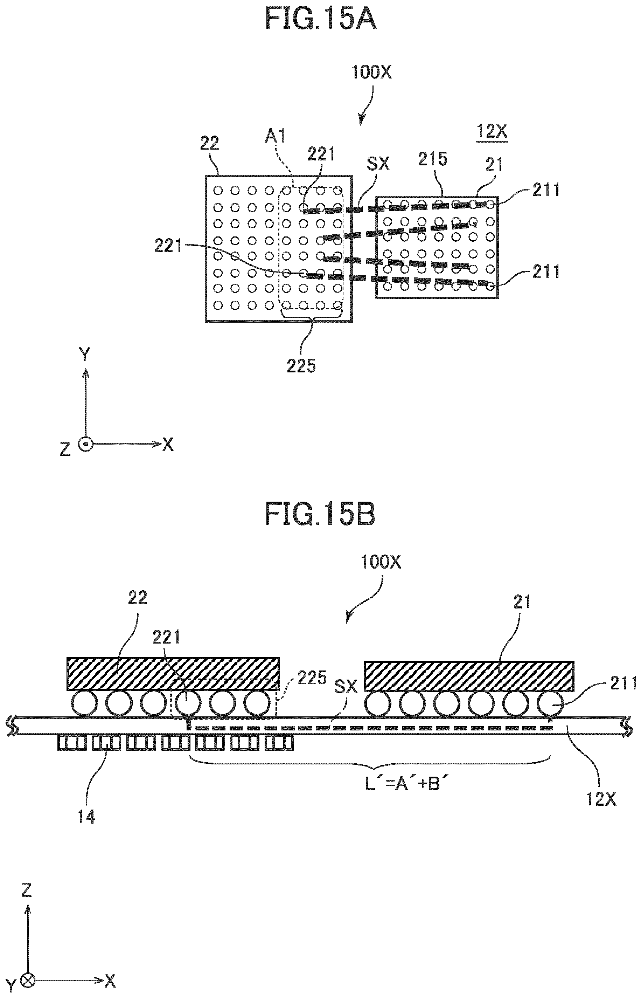

Next, an image processing module of a comparative example will be described. Each of FIGS. 15A and 15B is a diagram illustrating an image processing module 100X of Comparative Example 1. FIG. 15A illustrates a schematic plan view of the image processing module 100X of Comparative Example 1. FIG. 15B illustrates a schematic cross-sectional view of the image processing module 100X of Comparative Example 1. In FIGS. 15A and 15B, the image processing engine 22 and the memory 21 are mounted on a single wiring board 12X so as to lie flat on the wiring board 12X. Note that the plurality of capacitors 14 is mounted on a main surface of the wiring board 12X opposite to a main surface of the wiring board 12X on which the image processing engine 22 is mounted.

The memory 21 includes the plurality of signal terminals 211. The terminal group 225 of the image processing engine 22 includes the plurality of signal terminals 221. The wiring board 12X includes a plurality of signal wirings SX. The plurality of signal terminals 221 of the terminal group 225 is respectively connected to the plurality of signal terminals 211 via the plurality of corresponding signal wirings SX. Note that although each of the signal wirings SX is disposed straight in FIG. 15A, the signal wiring SX may be disposed so as to meander for detouring around pads, vias, and the like. In FIG. 15B, one of the plurality of signal wirings SX is illustrated. The signal wiring SX illustrated in FIG. 15B has the longest wiring length in the plurality of signal wirings SX.

A wiring length L' of the signal wirings SX illustrated in FIG. 15B is the sum of a wiring length A' on the image processing engine 22 side, and a wiring length B' on the memory 21 side. Note that the wiring length B' on the memory 21 side is longer than the length of the side 215 that is the long side of the memory 21. For example, the wiring length B' is almost equal to the length of the diagonal line of the memory 21.

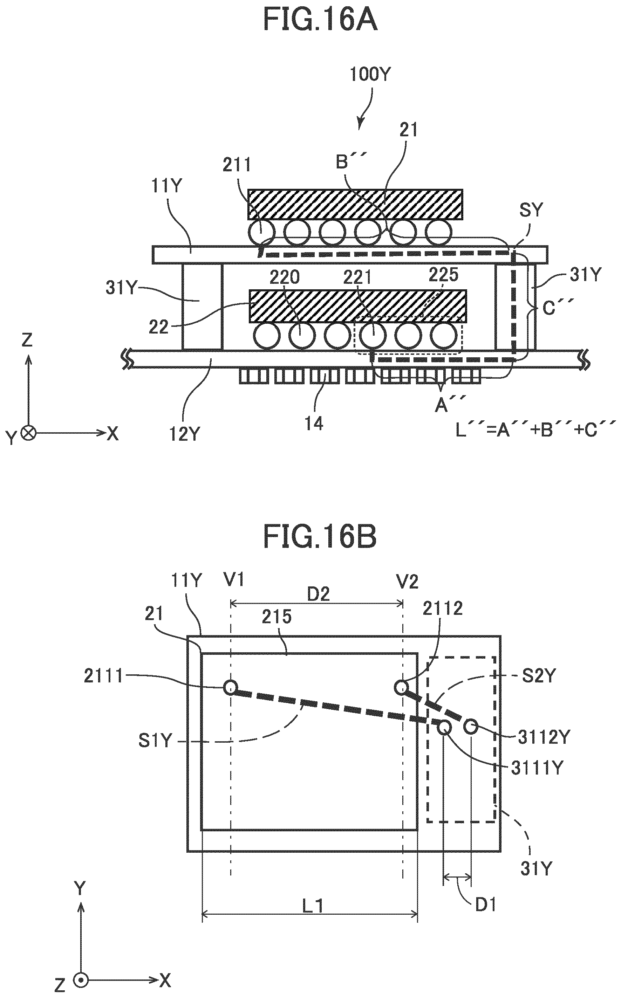

Each of FIGS. 16A and 16B is a diagram illustrating an image processing module 100Y of Comparative Example 2. FIG. 16A illustrates a schematic cross-sectional view of the image processing module 100Y of Comparative Example 2. FIG. 16B illustrates a schematic plan view of the image processing module 100Y of Comparative Example 2. The image processing module 100Y of Comparative Example 2 has a laminated structure. Since the image processing module 100Y of Comparative Example 2 has a laminated structure, the size of the image processing module 100Y is smaller than the size of the image processing module 100X of Comparative Example 1.

The memory 21 is mounted on a wiring board 11Y, and the image processing engine 22 is mounted on a wiring board 12Y The wiring board 11Y and the wiring board 12Y are connected with each other via two wiring members 31Y. The two wiring members 31Y are disposed on both sides of the image processing engine 22 in the X direction, each spaced from the image processing engine 22. That is, when viewed in the Z direction, the image processing engine 22 is positioned between the two wiring members 31Y. In addition, when viewed in the Z direction, the memory 21 is also positioned between the two wiring members 31Y.

In Comparative Example 2, each of a plurality of signal wirings SY is disposed so as to extend in the wiring board 11Y, a single wiring member 31Y, and the wiring board 12Y. The plurality of signal terminals 221 of the terminal group 225 is respectively connected to the plurality of signal terminals 211 via the plurality of corresponding signal wirings SY. In FIG. 16A, one of the plurality of signal wirings SY is illustrated. The signal wiring SY illustrated in FIG. 16A has the longest wiring length of the plurality of signal wirings SY.

A wiring length L" of the signal wiring SY illustrated in FIG. 16A is the sum of a wiring length A" on the image processing engine 22 side, a wiring length B" on the memory 21 side, and a wiring length C" of the wiring member 31Y in the height direction. Note that the wiring length B" on the memory 21 side is longer than the length of the side 215 that is the long side of the memory 21. The wiring length A" on the image processing engine 22 side, illustrated in FIG. 16A, is almost equal to the wiring length A' on the image processing engine 22 side, illustrated in FIG. 15B. The wiring length B" on the memory 21 side is almost equal to the wiring length B' on the memory 21 side, illustrated in FIG. 15B, or is longer than the wiring length B' by the width of the wiring member 31Y in the X direction.

Thus, the wiring length L" of the signal wiring SY, illustrated in FIG. 16A, is longer than the wiring length L' of the signal wiring SX, illustrated in FIG. 15B, because the wiring length L" includes the wiring length C". Since the wiring length L" of the signal wiring SY is longer, the digital signal transmitted through the signal wiring SY deteriorates. That is, although the image processing module 100Y of Comparative Example 2 is smaller than the image processing module 100X of Comparative Example 1, the transmission property of signals of the image processing module 100Y of Comparative Example 2 is lower than that of the image processing module 100X of Comparative Example 1.

In contrast, as illustrated in FIG. 2, in the first embodiment, the wiring length L of the signal wiring S is the sum of the wiring length A on the image processing engine 22 side, the wiring length B on the memory 21 side, and the wiring length C of the wiring member 31 in the height direction.

In comparison between the wiring length L and the wiring length L" illustrated in FIG. 16A, the wiring length A on the image processing engine 22 side is almost equal to the wiring length A" on the image processing engine 22 side. In addition, the wiring length C of the wiring member 31 is almost equal to the wiring length C" of the wiring member 31Y. However, the wiring length B on the memory 21 side is shorter than the wiring length B" on the memory 21 side, and is almost half the wiring length B". Thus, the wiring length L of the signal wiring S is shorter than the wiring length L" of the signal wiring SY of Comparative Example 2. As a result, the wiring characteristic is improved, and the signal transmitted through the wiring can be made faster.

In comparison between the wiring length L and the wiring length L' illustrated in FIG. 15B, the wiring length A on the image processing engine 22 side is almost equal to the wiring length A' on the image processing engine 22 side. However, the length obtained by adding the wiring length B and the wiring length C can be made shorter than the wiring length B' on the memory 21 side. In this case, the wiring length L of the signal wiring S is shorter than the wiring length L' of the signal wiring SX of Comparative Example 1. As a result, the wiring characteristic is improved, and the signal transmitted through the wiring can be made faster. Furthermore, when viewed in the Z direction, the area occupied by the image processing module 100 is smaller than the area occupied by the image processing module 100X of Comparative Example 1.

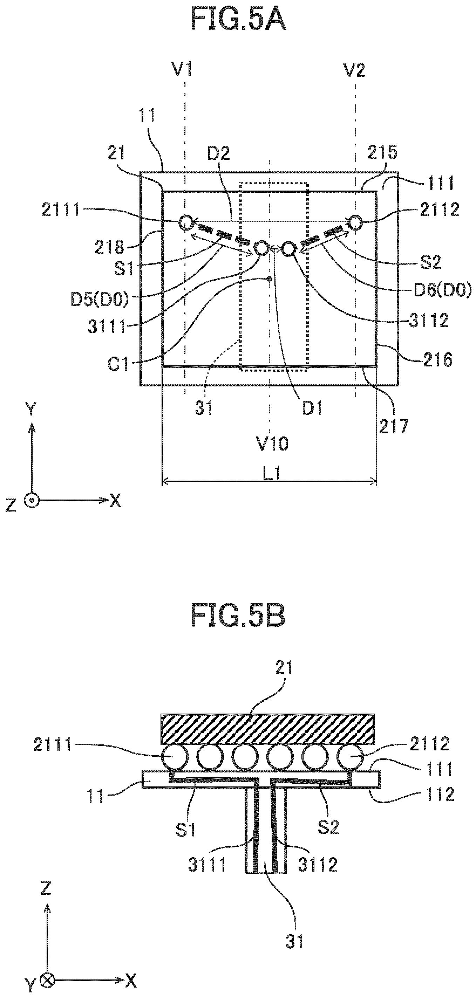

Each of FIGS. 5A and 5B is a diagram illustrating a positional relationship between the memory 21, the wiring board 11, and the wiring member 31 of the first embodiment. FIG. 5A is a plan view of the memory 21, the wiring board 11, and the wiring member 31. FIG. 5B is a cross-sectional view of the memory 21, the wiring board 11, and the wiring member 31.

In the Z direction, the wiring member 31 is disposed at a position at which the wiring member 31 overlaps with the center C1 of the memory 21. In addition, an imaginary plane V10 is defined as a plane that crosses the center of the side 215 and the center of the side 217, which are long sides of the memory 21. The imaginary plane V10 is an imaginary plane orthogonal to the main surface 111 of the wiring board 11.

A signal terminal 2111 is one of signal terminals 211 that are included in the plurality of signal terminals 211 of the memory 21, and that are positioned on the side 218 side with respect to the imaginary plane V10. Of the signal terminals 211 positioned on the side 218 side with respect to the plane imaginary V10, the signal terminal 2111 is the terminal farthest from the plane imaginary V10. The signal terminal 2111 is one example of a first signal terminal.

A signal terminal 2112 is one of signal terminals 211 that are included in the plurality of signal terminals 211 of the memory 21, and that are positioned on the side 216 side with respect to the imaginary plane V10. Of the signal terminals 211 positioned on the side 216 side with respect to the imaginary plane V10, the signal terminal 2112 is the terminal farthest from the imaginary plane V10. The signal terminal 2112 is one example of a second signal terminal.

That is, the signal terminals 2111 and 2112 of the plurality of signal terminals 211 are the two signal terminals, the separation distance between which is maximum in the X direction in which the sides 215 and 217 extend.

A signal wiring of the plurality of signal wirings S that is connected to the signal terminal 2111 is defined as a signal wiring S1. The signal wiring S1 is one example of a first signal wiring. The signal wiring S1 includes a wiring terminal 3111 that is a corresponding one of the plurality of wiring terminals 311 of the wiring member 31. The wiring terminal 3111 is one example of a first wiring terminal.

A signal wiring of the plurality of signal wirings S that is connected to the signal terminal 2112 is defined as a signal wiring S2. The signal wiring S2 is one example of a second signal wiring. The signal wiring S2 includes a wiring terminal 3112 that is a corresponding one of the plurality of wiring terminals 311 of the wiring member 31. The wiring terminal 3112 is one example of a second wiring terminal.

As described above, the signal terminal 2111 of the memory 21 is electrically connected to the image processing engine 22 via the wiring terminal 3111 of the wiring member 31. In addition, the signal terminal 2112 of the memory 21 is electrically connected to the image processing engine 22 via the wiring terminal 3112 of the wiring member 31.

In the first embodiment, as illustrated in FIGS. 5A and 5B, in the Z direction, the wiring terminals 3111 and 3112 overlap with the memory 21. In addition, in the Z direction, the signal terminals 2111 and 2112 do not overlap with the wiring member 31.

As illustrated in FIG. 5A, the wiring terminals 3111 and 3112 are disposed between an imaginary plane V1 and an imaginary plane V2. The imaginary plane V1 is one example of a first imaginary plane. The imaginary plane V2 is one example of a second imaginary plane.

In the first embodiment, the wiring member 31 is separated from the imaginary plane V1 and the imaginary plane V2, and disposed between the imaginary plane V1 and the imaginary plane V2. That is, the whole of the wiring member 31 is disposed between the imaginary plane V1 and the imaginary plane V2. The imaginary plane V1 is orthogonal to the main surface 111, and crosses the signal terminal 2111. The imaginary plane V2 is orthogonal to the main surface 111, and crosses the signal terminal 2112. When viewed in the Z direction, the imaginary plane V1 crosses the center of the signal terminal 2111, and the imaginary plane V2 crosses the center of the signal terminal 2112. The imaginary planes V1 and V2 are parallel to each other. In addition, the imaginary plane V1 and the imaginary plane V2 are not equal to each other. In addition, the imaginary planes V1 and V2 do not cross the wiring member 31. In the first embodiment, the imaginary planes V10, V1, and V2 are parallel to each other, and are not equal to each other. In addition, in the first embodiment, the imaginary planes V0, V10, V1, and V2 are parallel to each other, and are not equal to each other.

In addition, a distance D1 between the wiring terminal 3111 and the wiring terminal 3112 is smaller than a distance D2 between the signal terminal 2111 and the signal terminal 2112. In other words, the distance D2 is larger than the distance D1. Note that when viewed in the Z direction, the distance D1 serves also as a straight-line distance between the wiring terminal 3111 and the wiring terminal 3112. In addition, when viewed in the Z direction, the distance D2 serves also as a straight-line distance between the signal terminal 2111 and the signal terminal 2112.

Note that the imaginary plane V1 and the imaginary plane V2 can be defined in any way as long as the imaginary plane V1 and the imaginary plane V2 are parallel to each other. Typically, it is preferable that the imaginary plane V1 and the imaginary plane V2 be orthogonal to a line segment that connects the signal terminal 2111 and the signal terminal 2112. In this case, the distance D2 is a distance in a direction orthogonal to the imaginary plane V1 and the imaginary plane V2. In addition, the distance D1 is preferably a distance in a direction orthogonal to the imaginary plane V1 and the imaginary plane V2.

In contrast, in Comparative Example 2, as illustrated in FIG. 16B, the whole of the wiring member 31Y. does not overlap with the memory 21 in the Z direction. A signal wiring of the plurality of signal wirings SY that is connected to the signal terminal 2111 of the memory 21 is defined as a signal wiring S1Y. The signal wiring S1Y includes a wiring terminal 3111Y of the wiring member 31Y. In addition, a signal wiring of the plurality of signal wirings SY that is connected to the signal terminal 2112 is defined as a signal wiring S2Y. The signal wiring S2Y includes a wiring terminal 3112Y of the wiring member 31Y The distance between the wiring terminal 3111Y and the wiring terminal 3112Y is almost equal to the distance D1.

Of the plurality of the signal terminals 211, the signal terminal 2111 is the terminal farthest from the wiring member 31Y Of the plurality of the signal terminals 211, the signal terminal 2112 is the terminal nearest to the wiring member 31Y. Note that although a wiring path of the signal wiring S1Y that is included in the wiring board 11Y is illustrated with a straight line in FIG. 16B, the wiring path of the signal wiring S1Y that is included in the wiring board 11Y may meander for detouring around pads, vias, and the like. Similarly, although a wiring path of the signal wiring S2Y that is included in the wiring board 11Y is illustrated with a straight line, the wiring path of the signal wiring S2Y that is included in the wiring board 11Y may meander for detouring around pads, vias, and the like.

Thus, the wiring member 31Y. (that is, the wiring terminals 3111Y and 3112Y) is not disposed between the imaginary plane V1 and the imaginary plane V2, but disposed outside the area between the imaginary plane V1 and the imaginary plane V2. As a result, the length of a wiring path of the signal wiring S1Y of Comparative Example 2 that is included in the wiring board 11Y is longer than the length of the memory 21 in the X direction that is the longitudinal direction of the memory 21, that is, than a length L1 of the long side 215 (217).

In contrast, in the first embodiment, the length of a wiring path of the signal wiring S1 that is included in the wiring board 11 can be made almost equal to half the length L1 of the memory 21 in the longitudinal direction of the memory 21. In addition, the length of a wiring path of the signal wiring S2 that is included in the wiring board 11 can be made almost equal to half the length L1 of the memory 21 in the longitudinal direction of the memory 21. Thus, the wiring path of each of the plurality of signal wirings S can be made shorter.

Note that although a wiring path of the signal wiring S1 that is included in the wiring board 11 is illustrated with a straight line in FIG. 5A, the wiring path of the signal wiring S1 that is included in the wiring board 11 may meander for detouring around pads, vias, and the like. In addition, although a wiring path of the signal wiring S2 that is included in the wiring board 11 is illustrated with a straight line in FIG. 5A, the wiring path of the signal wiring S2 that is included in the wiring board 11 may meander for detouring around pads, vias, and the like.

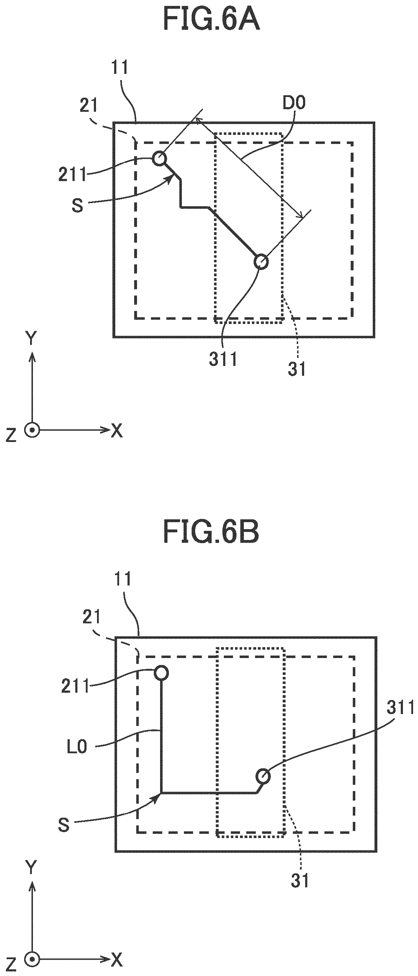

FIG. 6A is a diagram illustrating a distance between two terminals 211 and 311 of the first embodiment. The plurality of signal terminals 211 of the memory 21 and the plurality of wiring terminals 311 of the wiring member 31 have a plurality of pairs of two terminals, 211 and 311, which are electrically connected with each other via a signal wiring S. At least one of the plurality of pairs has two terminals 211 and 311, a distance D0 between which is maximum. FIG. 6A illustrates one of the plurality of pairs that has the maximum distance D0. The maximum distance D0 is a straight-line distance between the two terminals 211 and 311 obtained when the terminals are viewed in the Z direction. That is, the maximum distance D0 is a straight-line distance between the two terminals 211 and 311 in a direction along an XY plane.

The maximum distance D0 is shorter than the maximum length L1 of the sides 215 to 218 of the memory 21. The long side 215 (217) is longest in the plurality of sides 215 to 218. Thus, the maximum distance D0 is shorter than the length L1 of the side 215 (217).

FIG. 6B is a diagram illustrating a wiring length between two terminals 211 and 311 of the first embodiment. The plurality of signal terminals 211 of the memory 21 and the plurality of wiring terminals 311 of the wiring member 31 have a plurality of pairs of two terminals, 211 and 311, which are electrically connected with each other via a signal wiring S. At least one of the plurality of pairs has two terminals 211 and 311, a wiring length L0 between which is maximum. FIG. 6B illustrates one of the plurality of pairs that has the maximum wiring length L0. The maximum wiring length L0 is the length of a path between the two terminals 211 and 311 obtained when the terminals are viewed in the Z direction. That is, the length of a via is ignored in the maximum wiring length L0.

The maximum wiring length L0 is shorter than the maximum length L1 of the sides 215 to 218 of the memory 21. The long side 215 (217) is longest in the plurality of sides 215 to 218. Thus, the maximum wiring length L0 is shorter than the length L1 of the side 215 (217).

In addition, for reducing the difference between the wiring length, illustrated in FIG. 5A, between the signal terminal 2111 and the wiring terminal 3111, and the wiring length between the signal terminal 2112 and the wiring terminal 3112, it is preferable that a difference Dd between a distance D5 between the signal terminal 2111 and the wiring terminal 3111, and a distance D6 between the signal terminal 2112 and the wiring terminal 3112 be made smaller as much as possible.

The distance D5 is a straight-line distance between the signal terminal 2111 and the wiring terminal 3111 obtained when the signal terminal 2111 and the wiring terminal 3111 are viewed in the Z direction. The distance D6 is a straight-line distance between the signal terminal 2112 and the wiring terminal 3112 obtained when the signal terminal 2112 and the wiring terminal 3112 are viewed in the Z direction. Thus, the difference Dd is preferably smaller than the distance D2 between the signal terminal 2111 and the signal terminal 2112, and is more preferably smaller than the distance D1 between the wiring terminal 3111 and the wiring terminal 3112. That is, it is preferable that Dd = |D5 - D6| < D2, and it is more preferable that Dd = |D5 - D6| < D1.

In addition, the distances D5 and D6 may be larger than the distance D1, but are preferably made as small as possible for reducing the delay of signals. That is, the distances D5 and D6 are preferably smaller than the distance D2. That is, it is preferable that D5 >D1 and D6 > D1, and that D5 < D2 and D6 < D2.

In addition, even if the distance D5 is the above-described maximum distance D0, it is preferable that Dd = |D5 - D6| < D2, and it is more preferable that Dd = |D5 - D6| < D1.

In addition, even if the distance D6 is the above-described maximum distance D0 or the second-longest distance between terminals, it is preferable that Dd = |D5 - D6| < D2, and it is more preferable that Dd = |D5 - D6| < D1.

Note that although the description has been made for the case where the distances D0, D5, and D6 are straight-line distances obtained when the distances are viewed in the Z direction, the distances D0, D5, and D6 may be distances in consideration of the thickness of the wiring board 11.

Next, one example of the size of each component of the image processing module 100 will be described. The length of one side of the image processing engine 22 is about 15 to 20 mm. The length of one side of the memory 21 is about 10 to 20 mm. The length of the wiring member 31 in the longitudinal direction (Y direction) is almost equal to the length of one side of the image processing engine 22, and is about 15 to 20 mm. The length of the wiring member 31 in the lateral direction (X direction) is about 3 to 5 mm. The height of the wiring member 31 in the Z direction is about 0.5 to 5.0 mm. The maximum wiring length of the signal wiring SX of Comparative Example 1 is about 25 mm. The maximum wiring length of the signal wiring SY of Comparative Example 2 is about 30 mm. The maximum wiring length of the signal wiring S of the first embodiment is about 20 mm in a case where the height of the wiring member 31 is, for example, about 2 mm.

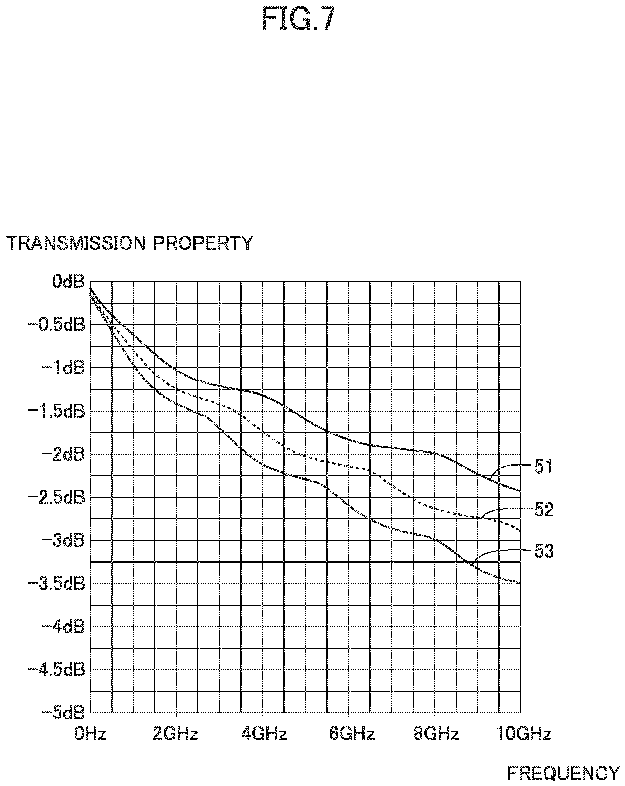

FIG. 7 is a graph illustrating transmission property of signals in a signal wiring in the first embodiment, a signal wiring in Comparative Example 1, and a signal wiring in Comparative Example 2. The vertical axis of the graph illustrated in FIG. 7 represents the transmission property of signals transmitted through a signal wiring, in units of dB. The transmission property of signals becomes better as the numerical value in dB becomes closer to 0. The horizontal axis represents the frequency illustrated in a range from 0 to 10 GHz.

In FIG. 7, a symbol 51 denotes the transmission property of signals transmitted through the signal wiring S of the first embodiment, a symbol 52 denotes the transmission property of signals transmitted through the signal wiring SX of Comparative Example 1, and a symbol 53 denotes the transmission property of signals transmitted through the signal wiring SY of Comparative Example 2. FIG. 7 illustrates results of an experiment conducted for the signal wiring SY of Comparative Example 2 having a wiring length of about 30 mm, the signal wiring SX of Comparative Example 1 having a wiring length of about 25 mm, and the signal wiring S of the first embodiment having a wiring length of about 20 mm. In a case where the transmission property equal to or larger than -2dB is required at a frequency multiplication of 1 in high-speed transmission of signals, the image processing engine 22 can operate at an operating speed lower than 4 GHz in Comparative Example 2, and an operating speed lower than 5 GHz in Comparative Example 1. In the first embodiment, however, the image processing engine 22 can operate at an operating speed up to about 8 GHz.

In the first embodiment, since the transmission property of signals transmitted through the signal wiring S is improved, the transmission speed of signals transmitted through the signal wiring S can be increased. Thus, the first embodiment provides the technique advantageous for increasing the transmission speed of signals.

In the first embodiment, as illustrated in FIGS. 2 and 3A, in the Z direction, the image processing engine 22 overlaps with the wiring board 11. Specifically, in the Z direction, one portion of the image processing engine 22 overlaps with the wiring board 11. That is, at least one portion of the image processing engine 22 is disposed in a space between the wiring board 11 and the wiring board 12. Thus, since the image processing engine 22 is disposed closer to the wiring member 31, the image processing module 100 is made smaller, and the wiring length of the signal wiring S is made shorter. As a result, the transmission property of signals is further improved, and the transmission speed of signals can be made faster.

In addition, in the first embodiment, as illustrated in FIG. 3B, the plurality of terminals 220 of the image processing engine 22 includes signal terminals 221 that overlap with the wiring board 11 in the Z direction. That is, the plurality of signal terminals 221 of the image processing engine 22 includes at least one signal terminal 221 that overlaps with the wiring board 11. The signal terminal 221 that overlaps with the wiring board 11 is electrically connected to a corresponding one of the plurality of signal terminals 211 of the memory 21 illustrated in FIG. 4A, via the signal wiring S. In the first embodiment, a signal terminal 221 included in the terminal group 225 is electrically connected to a corresponding one of the plurality of signal terminals 211 of the memory 21 via the signal wiring S. In the image processing module 100, the wiring length of the signal wiring S is made shorter, and the transmission speed of signals can be made faster.

In the X direction, at least one of the signal terminals 221 included in the image processing engine 22 preferably overlaps with the memory 21. In the first embodiment, in the X direction, at least one of the signal terminals 221 included in the terminal group 225 preferably overlaps with the memory 21. In this manner, the signal wiring S can be made shorter.

In addition, in the X direction, at least one of the plurality of capacitors 14 preferably overlaps with the wiring board 11. Furthermore, in the X direction, at least one of the plurality of capacitors 14 more preferably overlaps with the memory 21.

### Second Embodiment

Next, a second embodiment of the present disclosure will be described. In the following description, a component given an identical reference symbol of a component of the first embodiment has substantially the same configuration and effects as those of the component described in the first embodiment, unless otherwise specified, and features different from those of the first embodiment will be mainly described.

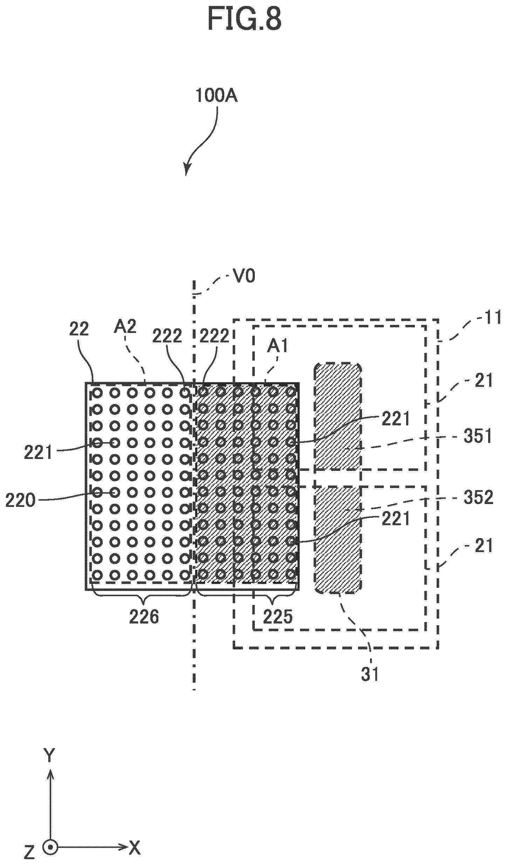

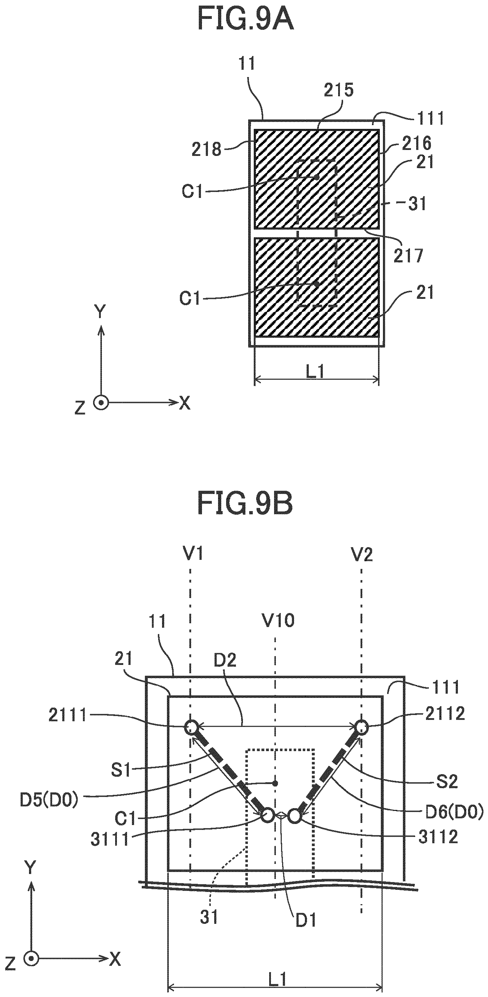

FIG. 8 is a plan view illustrating a relationship in arrangement between an image processing engine 22, a memory 21, a wiring board 11, and a wiring member 31 of an image processing module 100A of the second embodiment. FIG. 9A is a plan view illustrating a relationship in arrangement between the memory 21, the wiring board 11, and the wiring member 31 of the image processing module 100A of the second embodiment. FIG. 9B is a diagram illustrating a positional relationship between the memory 21, the wiring board 11, and the wiring member 31 of the image processing module 100A of the second embodiment.

In the second embodiment, in the camera 600 illustrated in FIG. 1, the image processing module 100A is used instead of the image processing module 100. In the second embodiment, the image processing module 100A includes two memories 21 mounted on the wiring board 11. One of the two memories 21 is one example of a first semiconductor device, and the other of the two memories 21 is one example of a third semiconductor device. That is, the image processing module 100A of the second embodiment differs from the image processing module 100 of the first embodiment in that the image processing module 100A includes the two memories 21. The configuration and the relationship in arrangement of the other components are the same as those described in the first embodiment.

The two memories 21 are electrically connected to the image processing engine 22 via the wiring member 31. The two memories 21 are mounted on the main surface 111 of the wiring board 11, spaced from each other in the Y direction that is the lateral direction of each of the memories 21. In addition, in the Z direction, the wiring member 31 overlaps with the two memories 21. In the second embodiment, the wiring member 31 overlaps with a center C1 of each of the two memories 21. In addition, in the Z direction, the wiring board 11 and each of the two memories 21 overlap with signal terminals 221 of the image processing engine 22. The relationship between the imaginary planes V1, V2, and V10 and terminals 2111, 2112, 3111, and 3112, illustrated in FIG. 9B, is also the same as that described in the first embodiment.

In the second embodiment, the wiring member 31 includes a first portion 351 and a second portion 352. The first portion 351 is positioned between one of the two memories 21 and the wiring board 12 in the Z direction. The second portion 352 is positioned between the other of the two memories 21 and the wiring board 12 in the Z direction. One of the two memories 21 is electrically connected to the image processing engine 22 via the first portion 351, and the other of the two memories 21 is electrically connected to the image processing engine 22 via the second portion 352.

Side surfaces of the insulating board of the wiring member 31 surround a wiring group that connects one of the two memories 21 and the image processing engine 22, and a wiring group that connects the other of the two memories 21 and the image processing engine 22. That is, the wiring groups that connect the two memories 21 and the image processing engine 22 is disposed in the wiring member 31 that is supported by the insulating board used for both of the wiring groups.

Note that the two memories 21 may have the same configuration (type) as each other, or may have configurations (types) different from each other. For example, one of the two memories 21 may have a memory capacity of 1 GB, and the other of the two memories 21 may have a memory capacity of 2 GB. Like this, the two memories 21 may have configurations (types) different from each other.

The second embodiment produces the same effects as those of the first embodiment. That is, like the first embodiment, the second embodiment provides the technique advantageous for increasing the transmission speed of signals.

### Third Embodiment

Next, a third embodiment of the present disclosure will be described. In the following description, a component given an identical reference symbol of a component of the first or the second embodiment has substantially the same configuration and effects as those of the component described in the first or the second embodiment, unless otherwise specified, and features different from those of the first and the second embodiments will be mainly described.

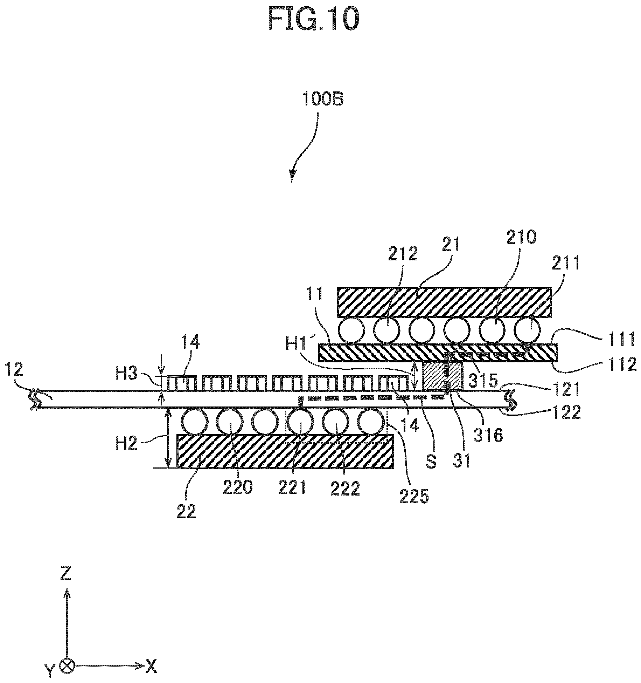

FIG. 10 is a diagram illustrating an image processing module 100B that is one example of an electronic module of the third embodiment. FIG. 10 schematically illustrates a cross section of the image processing module 100B, taken along an XZ plane.

In the third embodiment, in the camera 600 illustrated in FIG. 1, the image processing module 100B is used instead of the image processing module 100. The image processing module 100B of the third embodiment differs from the image processing module 100 of the first embodiment in the arrangement of the image processing engine 22 and the capacitors 14. That is, in the third embodiment, the image processing engine 22 is mounted on the main surface 122 of the wiring board 12, and the plurality of capacitors 14 is mounted on the main surface 121.

In the Z direction, the plurality of capacitors 14 overlaps with the image processing engine 22. In addition, in the Z direction, at least one portion of the image processing engine 22 and at least one of the plurality of capacitors 14 overlap with the wiring board 11. That is, at least one of the plurality of capacitors 14 is disposed in a space (area) between the wiring board 11 and the wiring board 12.

The height H3 of the capacitors 14 in the Z direction is smaller than the height H2 of the image processing engine 22 in the Z direction. Thus, in the third embodiment, a distance H1' between the main surface 112 of the wiring board 11 and the main surface 121 of the wiring board 12 in the Z direction (that is, the height of the wiring member 31 in the Z direction) can be made smaller than the distance H1 illustrated in FIG. 2. As a result, the third embodiment produces the same effects as those of the first embodiment, and the image processing module 100B can be made smaller than the image processing module 100 of the first embodiment.

In the third embodiment, in the Z direction, at least one portion of the image processing engine 22 and at least one of the plurality of capacitors 14 overlap with the memory 21. Thus, the image processing module 100B can be made smaller.

In the third embodiment, as in the first embodiment, the description has been made for the case where the image processing module 100B includes the single memory 21 mounted on the wiring board 11. However, the present disclosure is not limited to this. For example, as in the second embodiment, the image processing module 100B may include a plurality of (e.g., two) memories 21 mounted on the wiring board 11.

### Fourth Embodiment

Next, a fourth embodiment of the present disclosure will be described. In the following description, a component given an identical reference symbol of a component of the first, the second, or the third embodiment has substantially the same configuration and effects as those of the component described in the first, the second, or the third embodiment, unless otherwise specified, and features different from those of the first, the second, and the third embodiments will be mainly described.

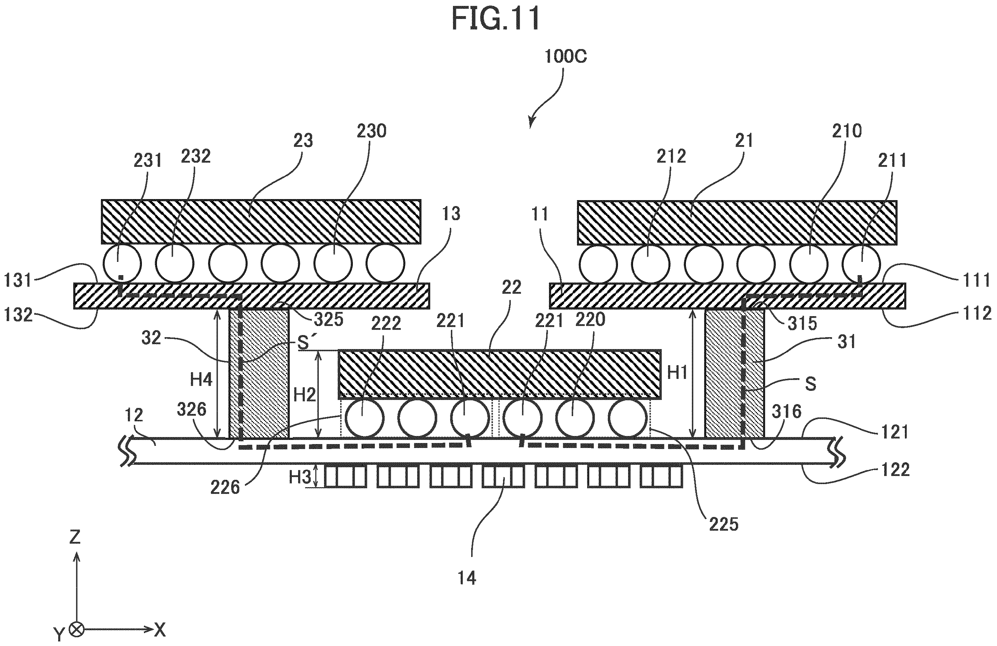

FIG. 11 is a diagram illustrating an image processing module 100C that is one example of an electronic module of the fourth embodiment. FIG. 11 schematically illustrates a cross section of the image processing module 100C, taken along an XZ plane.

In the fourth embodiment, in the camera 600 illustrated in FIG. 1, the image processing module 100C is used instead of the image processing module 100. In addition to the configuration of the image processing module 100 of the first embodiment, the image processing module 100C of the fourth embodiment includes a wiring board 13 that is one example of a third wiring board, a memory 23 that is one example of a fourth semiconductor device, and a wiring member 32 that is one example of a second wiring member.

Side surfaces of the insulating board of the wiring member 31 surround the plurality of wirings of the wiring member 31, and side surfaces of the insulating board of the wiring member 32 surround the plurality of wirings of the wiring member 32. The wiring member 31 and the wiring member 32 are disposed, separated from each other.

The memory 23 is, for example, a memory device such as a DRAM or a flash memory. The DRAM may be a DDR5. The image processing engine 22 functions also as a memory controller that controls the memory 23. The image processing engine 22 can store image data in the memory 23, and read the image data stored in the memory 23.

The memory 23 is a semiconductor device. The memory 23 is a semiconductor package that includes a semiconductor integrated circuit, and may be a BGA or an LGA. Note that the semiconductor package is preferably any one of the above-described types, but is not limited to the types. For example, the semiconductor package may be any one of various semiconductor packages, such as QFP, QFN, QFJ, or CSP. Preferably, the memory 23 has the same type (configuration) as that of the memory 21. However, the memory 23 may have a type (configuration) different from that of the memory 21.

The memory 23 includes a plurality of terminals 230 arranged in a matrix and spaced from each other in a direction along an XY plane. The plurality of terminals 230 of the memory 23 includes a plurality of signal terminals 231 and a plurality of feed terminals 232. Each of the feed terminals 232 is a power supply terminal or a ground terminal.

The wiring board 13 is a memory board (sub-board). The wiring board 13 is a rigid printed wiring board. In addition, the memory 23 is mounted on the wiring board 13.

The wiring board 13 includes a main surface 131 that is a mounting surface, and a main surface 132 that is a mounting surface. The main surface 132 is a main surface opposite to the main surface 131. The main surface 131 is one example of a fifth main surface, and the main surface 132 is one example of a sixth main surface.

The wiring board 13 and the wiring board 12 are disposed, spaced from each other in the Z direction. In the Z direction, the main surface 132 of the wiring board 13 faces the main surface 121 of the wiring board 12.

The main surfaces 111, 112, 121, 122, 131, and 132 are substantially parallel with each other. Thus, the direction orthogonal to the main surface 111 of the wiring board 11 is substantially the same as the direction orthogonal to the main surface 131 of the wiring board 13, and the direction orthogonal to the main surface 132 of the wiring board 13.

In the Z direction (when viewed in the Z direction), the wiring board 13 overlaps with the wiring board 12. In other words, in the Z direction, the wiring board 12 overlaps with the wiring board 13.

In the fourth embodiment, in the Z direction, the size of the wiring board 13 is smaller than the size of the wiring board 12. In addition, in the Z direction, at least one portion of the wiring board 13 overlaps with one portion of the wiring board 12. In the fourth embodiment, in the Z direction, the whole of the wiring board 13 overlaps with one portion of the wiring board 12. In other words, in the Z direction, one portion of the wiring board 12 overlaps with the whole of the wiring board 13.

The memory 23 is mounted on the main surface 131 of the wiring board 13. The image processing engine 22 is mounted on the main surface 121 of the wiring board 12. The plurality of capacitors 14 is mounted on the main surface 122 of the wiring board 12. Preferably, each of the capacitors 14 is disposed closer to the image processing engine 22. In the fourth embodiment, in the Z direction, each of the capacitors 14 overlaps with the image processing engine 22. Note that the plurality of capacitors 14 may include a capacitor 14 that does not overlap with the image processing engine 22 in the Z direction. In addition, in the Z direction, some of the plurality of capacitors 14 overlap with the wiring board 13. In addition, in the Z direction, some of the plurality of capacitors 14 overlap with the memory 23.

In the fourth embodiment, the memory 23 is surface-mounted on the main surface 131 of the wiring board 13. The image processing engine 22 is surface-mounted on the main surface 121 of the wiring board 12. The capacitors 14 are chip components, and are surface-mounted on the main surface 122 of the wiring board 12.

The wiring member 32 is disposed between the wiring board 13 and the wiring board 12, and electrically and mechanically connects the wiring board 13 and the wiring board 12. Specifically, the wiring member 32 is disposed between the main surface 132 of the wiring board 13 and the main surface 121 of the wiring board 12, and electrically and mechanically connects the main surface 132 of the wiring board 13 and the main surface 121 of the wiring board 12.

The wiring member 32 includes a joining surface 325 that is a third joining surface, and a joining surface 326 that is a fourth joining surface (mounting surface) opposite to the joining surface 325. The joining surface 325 of the wiring member 32 is electrically and mechanically connected to the main surface 132 of the wiring board 13 via a plurality of joining members, and the joining surface 326 of the wiring member 32 is electrically and mechanically connected to the main surface 121 of the wiring board 12 via a plurality of joining members. For example, each of the joining members is solder. The wiring member 32 functions also as a spacer between the wiring board 13 and the wiring board 12. In the fourth embodiment, the wiring member 32 is a rigid wiring board.

A distance H4 between the main surface 132 of the wiring board 13 and the main surface 121 of the wiring board 12 in the Z direction is larger than the height H2 of the image processing engine 22 in the Z direction. In addition, the wiring member 32 and the image processing engine 22 are disposed adjacent to each other in the X direction. That is, in the X direction, the wiring member 32 is disposed opposite to the wiring member 31 with respect to the image processing engine 22. In addition, in the Z direction, the image processing engine 22 overlaps with the wiring board 13. Note that the height H3 of the capacitors 14 in the Z direction is smaller than the height H2 of the image processing engine 22 in the Z direction.

The plurality of terminals 230 of the memory 23 includes a plurality of signal terminals 231. In FIG. 11, one of the plurality of signal terminals 231 is given a symbol. The plurality of signal terminals 231 of the memory 23 is electrically connected to the plurality of corresponding signal terminals 221 of the image processing engine 22 via a plurality of signal wirings S'. In FIG. 11, one of the plurality of signal wirings S' is illustrated. The signal wiring S' illustrated in FIG. 11 has the longest wiring length in the plurality of signal wirings S'. The plurality of signal wirings S' can be used for data transmission between the image processing engine 22 and the memory 23. That is, digital signals are transmitted through each of the plurality of signal wirings S'.

Each of the signal wirings S' is disposed so as to extend in the wiring board 13, the wiring member 32, and the wiring board 12. That is, each of the signal wirings S' includes a conductor included in the wiring board 13, a conductor included in the wiring member 32, and a conductor included in the wiring board 12. That is, the wiring path of each of the signal wirings S' from the memory 23 to the image processing engine 22 extends through the wiring member 32.

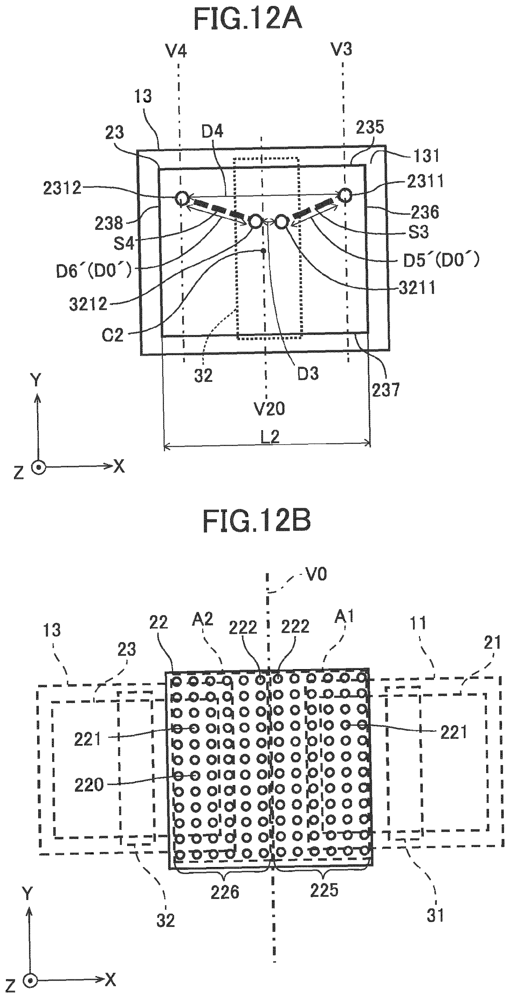

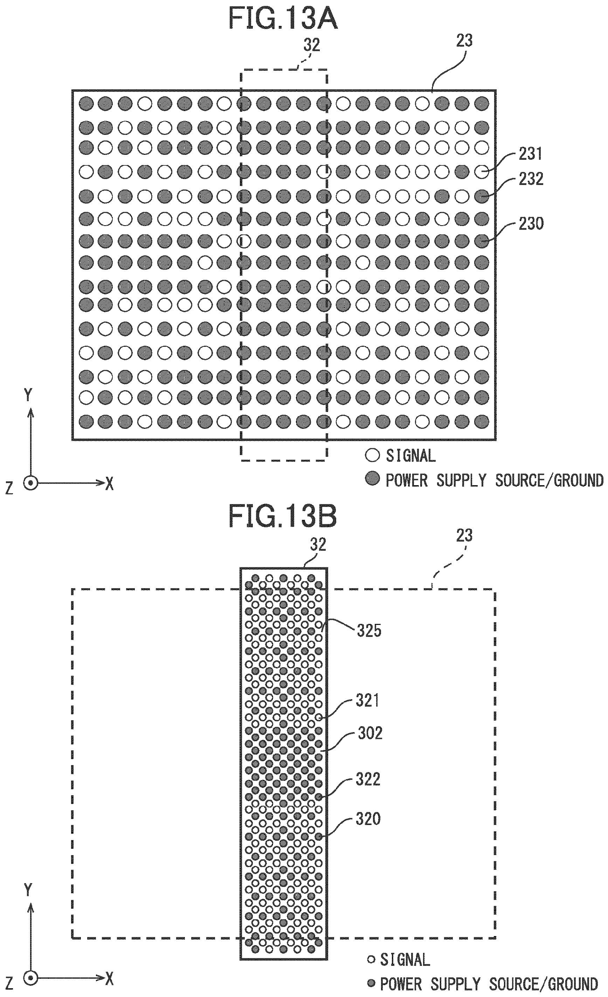

FIG. 12A is a plan view illustrating a relationship in arrangement between the memory 23, the wiring board 13, and the wiring member 32 of the image processing module 100C of the fourth embodiment. FIG. 12B is a plan view illustrating a relationship in arrangement between the image processing engine 22, the memories 21 and 23, the wiring boards 11 and 13, and the wiring members 31 and 32 of the fourth embodiment. Each of FIGS. 13A and 13B is a plan view illustrating a relationship in arrangement between the memory 23 and the wiring member 32 of the fourth embodiment. Note that in FIG. 13B, the joining surface 325 of the wiring member 32 is illustrated.

As illustrated in FIG. 12A, in the Z direction (when viewed in the Z direction), each of the wiring board 13 and the memory 23 has a rectangular shape, and the size of the wiring board 13 is equal to or larger than the size of the memory 23. When viewed in the Z direction, the memory 23 may have a square shape. In the fourth embodiment, the memory 23 has a rectangular shape. In addition, when viewed in the Z direction, the four corner portions of the memory 23 may be sharp, R-chamfered, or C-chamfered.

In the fourth embodiment, the longitudinal direction of the memory 23 is the X direction, and the lateral direction of the memory 23 is the Y direction. Note that the longitudinal direction of the memory 23 may be the Y direction, and the lateral direction of the memory 23 may be the X direction.

In the Z direction, the wiring member 32 overlaps with a center C2 of the memory 23. When viewed in the Z direction, the center C2 is a point at which two diagonal lines of the memory 23 cross each other. In addition, as illustrated in FIG. 12A, when viewed in the Z direction, the wiring member 32 has a rectangular shape, and the size of the wiring member 32 is smaller than the size of the wiring board 13. In addition, in the Z direction, the whole of the wiring member 32 overlaps with one portion of the wiring board 13.

When viewed in the Z direction, the outer shape of the memory 23 is rectangular. Thus, the memory 23 has four sides 235, 236, 237, and 238. The opposite two sides 235 and 237 of the four sides 235 to 238 are long sides, and the opposite two sides 236 and 238 are short sides. That is, each of the sides 235 and 237 is longest in the sides included in the memory 23. Each of the sides 235 and 237 extends in the X direction, and each of the sides 236 and 238 extends in the Y direction. That is, the sides 235 and 237 are parallel to each other, and the sides 236 and 238 are parallel to each other. The sides 236 and 238 are orthogonal to the sides 235 and 237.

The wiring member 32 is formed like a rectangular parallelopiped or a flat plate. As illustrated in FIGS. 13B, the wiring member 32 includes a plurality of terminals 320 disposed in the joining surface 325, and a plurality of terminals (not illustrated) disposed in the joining surface 326. The wiring member 32 includes an insulating board 302. The insulating board 302 is a rigid insulating board formed like a rectangular parallelopiped or a flat plate. The insulating board 302 has a plurality of through-holes that passes through the insulating board 302 in the Z direction. In each of the plurality of through-holes, a via conductor that serves as a wiring is disposed. Each of the plurality of via conductors is disposed in a corresponding through-hole so as to extend from a third end surface to a fourth end surface of the insulating board 302 in the Z direction. In addition, each of the plurality of via conductors is electrically connected with a corresponding terminal 320 of the plurality of terminals 320 of the joining surface 325, and with a corresponding terminal of the plurality of terminals of the joining surface 326.

As illustrated in FIG. 13B, in the Z direction (when viewed in the Z direction), the wiring member 32 has a rectangular shape. When viewed in the Z direction, the wiring member 32 may have a square shape. In the fourth embodiment, the wiring member 32 has a rectangular shape. In addition, when viewed in the Z direction, the four corner portions of the wiring member 32 may be sharp, R-chamfered, or C-chamfered. In the fourth embodiment, the longitudinal direction of the wiring member 32 is the Y direction, and the lateral direction of the wiring member 32 is the X direction.

Note that in FIG. 12B, the plurality of terminals 220 of the image processing engine 22 is schematically illustrated with solid lines. In addition, in FIG. 13A, the plurality of terminals 230 of the memory 23 is schematically illustrated with solid lines. In addition, in FIG. 13B, the plurality of terminals 320 of the wiring member 32 is schematically illustrated with solid lines.

As illustrated in FIG. 13A, the plurality of terminals 230 of the memory 23 is arranged in a matrix and spaced from each other in a direction along an XY plane. The plurality of terminals 230 includes a plurality of signal terminals 231 and a plurality of feed terminals 232. Each of the feed terminals 232 is a power supply terminal or a ground terminal. Each of the signal terminals 231 is a terminal for inputting or outputting a signal. Each of the feed terminals 232 is a terminal to which a voltage (i.e., a potential difference between a power supply potential and a ground potential) necessary for operating the memory 23 is applied. Note that in FIG. 13A, a white circle represents a signal terminal 231 and a gray circle represents a feed terminal 232.

As illustrated in FIG. 13B, the plurality of terminals 320 of the joining surface 325 of the wiring member 32 is arranged in a matrix and spaced from each other in a direction along an XY plane. Although not illustrated, the plurality of terminals of the joining surface 326 is arranged in a matrix and spaced from each other in a direction along an XY plane. The plurality of terminals 320 includes a plurality of wiring terminals 321 and a plurality of wiring terminals 322. Each of the wiring terminals 321 is used as one portion of a signal wiring S'. Each of the wiring terminals 322 is used as one portion of a power supply wiring or a ground wiring, which is used for supplying electric power to the memory 23. Note that in FIG. 13B, a white circle represents a wiring terminal 321 and a gray circle represents a wiring terminal 322.

As illustrated in FIG. 12B, when viewed in the Z direction, the size of the image processing engine 22 is equal to or larger than the size of the memory 23. Each of the signal terminals 211 (FIG. 11) of the memory 21 is electrically connected to a corresponding signal terminal 221 of the signal terminals 221 included in the terminal group 225, via the signal wiring S. In addition, each of the signal terminals 231 of the memory 23 is electrically connected to a corresponding signal terminal 221 of the signal terminals 221 included in the terminal group 226, via the signal wiring S'.

In this manner, the plurality of signal terminals 231 of the memory 23 is electrically connected to the image processing engine 22 via the plurality of corresponding wiring terminals 321 of the wiring member 32. The memory 23 and the wiring board 13 are joined with each other by using solder. In addition, the wiring member 32 and the wiring board 13 are joined with each other by using solder, and the wiring member 32 and the wiring board 12 are joined with each other by using solder.

Each of the plurality of terminals 230 of the memory 23 includes a pad (or a land). Each of the plurality of terminals 220 of the image processing engine 22 includes a pad (or a land). Each of the plurality of terminals 320 of the joining surface 325 of the wiring member 32 includes a pad (or a land). Each of the plurality of terminals of the joining surface 326 of the wiring member 32 includes a pad (or a land).

The plurality of terminals 230 included in the memory 23 and the plurality of pads included in the main surface 131 of the wiring board 13 are respectively joined with each other via solder. In addition, the plurality of pads included in the main surface 132 of the wiring board 13 and the plurality of terminals 320 included in the joining surface 325 of the wiring member 32 are respectively joined with each other via solder. In addition, the plurality of pads included in the main surface 121 of the wiring board 12 and the plurality of terminals included in the joining surface 326 of the wiring member 32 are respectively joined with each other via solder.

In addition, two electrodes of each of the plurality of capacitors 14 and two pads included in the main surface 122 of the wiring board 12 are respectively joined with each other via solder.

In the Z direction, the wiring member 32 is disposed at a position at which the wiring member 32 overlaps with the center C2 of the memory 23. In addition, an imaginary plane V20 is defined as a plane that crosses the center of the side 235 and the center of the side 237, which are long sides of the memory 23. The imaginary plane V20 is an imaginary plane orthogonal to the main surface 131 of the wiring board 13.

A signal terminal 2311 is one of signal terminals 231 that are included in the plurality of signal terminals 231 of the memory 23, and that are positioned on the side 236 side with respect to the imaginary plane V20. Of the signal terminals 231 positioned on the side 236 side with respect to the imaginary plane V20, the signal terminal 2311 is the terminal farthest from the imaginary plane V20. The signal terminal 2311 is one example of a third signal terminal.

A signal terminal 2312 is one of signal terminals 231 that are included in the plurality of signal terminals 231 of the memory 23, and that are positioned on the side 238 side with respect to the imaginary plane V20. Of the signal terminals 231 positioned on the side 238 side with respect to the imaginary plane V20, the signal terminal 2312 is the terminal farthest from the imaginary plane V20. The signal terminal 2312 is one example of a fourth signal terminal.

That is, the signal terminals 2311 and 2312 of the plurality of signal terminals 231 are the two signal terminals, the separation distance between which is maximum in the X direction in which the sides 235 and 237 extend.

A signal wiring of the plurality of signal wirings S' that is connected to the signal terminal 2311 is defined as a signal wiring S3. The signal wiring S3 is one example of a third signal wiring. The signal wiring S3 includes a wiring terminal 3211 that is a corresponding one of the plurality of wiring terminals 321 of the wiring member 32. The wiring terminal 3211 is one example of a third wiring terminal.

A signal wiring of the plurality of signal wirings S' that is connected to the signal terminal 2312 is defined as a signal wiring S4. The signal wiring S4 is one example of a fourth signal wiring. The signal wiring S4 includes a wiring terminal 3212 that is a corresponding one of the plurality of wiring terminals 321 of the wiring member 32. The wiring terminal 3212 is one example of a fourth wiring terminal.

As described above, the signal terminal 2311 of the memory 23 is electrically connected to the image processing engine 22 via the wiring terminal 3211 of the wiring member 32. In addition, the signal terminal 2312 of the memory 23 is electrically connected to the image processing engine 22 via the wiring terminal 3212 of the wiring member 32.

In the fourth embodiment, as illustrated in FIG. 12A, in the Z direction, the wiring terminals 3211 and 3212 overlap with the memory 23. In addition, in the Z direction, the signal terminals 2311 and 2312 do not overlap with the wiring member 32.

As illustrated in FIG. 12A, the wiring terminals 3211 and 3212 are disposed between an imaginary plane V3 and an imaginary plane V4. The imaginary plane V3 is one example of a third imaginary plane. The imaginary plane V4 is one example of a fourth imaginary plane.

In the fourth embodiment, the wiring member 32 is separated from the imaginary plane V3 and the imaginary plane V4, and disposed between the imaginary plane V3 and the imaginary plane V4. That is, the whole of the wiring member 32 is disposed between the imaginary plane V3 and the imaginary plane V4. The imaginary plane V3 is orthogonal to the main surface 131, and crosses the signal terminal 2311. The imaginary plane V4 is orthogonal to the main surface 131, and crosses the signal terminal 2312. When viewed in the Z direction, the imaginary plane V3 crosses the center of the signal terminal 2311, and the imaginary plane V4 crosses the center of the signal terminal 2312. The imaginary planes V3 and V4 are parallel to each other. In addition, the imaginary plane V3 and the imaginary plane V4 are not equal to each other. In addition, the imaginary planes V3 and V4 do not cross the wiring member 32. In the fourth embodiment, the imaginary planes V20, V3, and V4 are parallel to each other, and are not equal to each other. In addition, in the fourth embodiment, the imaginary planes V0, V20, V3, and V4 are parallel to each other, and are not equal to each other.

In addition, a distance D3 between the wiring terminal 3211 and the wiring terminal 3212 is smaller than a distance D4 between the signal terminal 2311 and the signal terminal 2312. In other words, the distance D4 is larger than the distance D3. Note that when viewed in the Z direction, the distance D3 serves also as a straight-line distance between the wiring terminal 3211 and the wiring terminal 3212. In addition, when viewed in the Z direction, the distance D4 serves also as a straight-line distance between the signal terminal 2311 and the signal terminal 2312.

Note that the imaginary plane V3 and the plane V4 can be defined in any way as long as the imaginary plane V3 and the imaginary plane V4 are parallel to each other. Typically, it is preferable that the imaginary plane V3 and the imaginary plane V4 be orthogonal to a line segment that connects the signal terminal 2311 and the signal terminal 2312. In this case, the distance D4 is a distance in a direction orthogonal to the imaginary plane V3 and the imaginary plane V4. In addition, the distance D3 is preferably a distance in a direction orthogonal to the imaginary plane V3 and the imaginary plane V4.

In the fourth embodiment, the length of a wiring path of the signal wiring S3 that is included in the wiring board 13 can be made almost equal to half the length L2 of the memory 23 in the longitudinal direction of the memory 23. In addition, the length of a wiring path of the signal wiring S4 that is included in the wiring board 13 can be made almost equal to half the length L2 of the memory 23 in the longitudinal direction of the memory 23. Thus, the wiring path of each of the plurality of signal wirings S' can be made shorter.

Note that although a wiring path of the signal wiring S3 that is included in the wiring board 13 is illustrated with a straight line in FIG. 12A, the wiring path of the signal wiring S3 that is included in the wiring board 13 may meander for detouring around pads, vias, and the like. In addition, although a wiring path of the signal wiring S4 that is included in the wiring board 13 is illustrated with a straight line in FIG. 12A, the wiring path of the signal wiring S4 that is included in the wiring board 13 may meander for detouring around pads, vias, and the like.

The plurality of signal terminals 231 of the memory 23 and the plurality of wiring terminals 321 of the wiring member 32 have a plurality of pairs of two terminals, 231 and 321, which are electrically connected with each other via a signal wiring S'. At least one of the plurality of pairs has two terminals 231 and 321, a distance D0' between which is maximum. The maximum distance D0' is a straight-line distance between the two terminals 231 and 321 obtained when the terminals are viewed in the Z direction. That is, the maximum distance D0' is a straight-line distance between the two terminals 231 and 321 in a direction along an XY plane.

The maximum distance D0' is shorter than the maximum length L2 of the sides 235 to 238 of the memory 23. The long side 235 (237) is longest in the plurality of sides 235 to 238. Thus, the maximum distance D0' is shorter than the length L2 of the side 235 (237). Note that in the fourth embodiment, since the memory 23 has the same configuration as that of the memory 21, the length L2 is equal to the length L1 illustrated in FIG. 5A.

The plurality of signal terminals 231 of the memory 23 and the plurality of wiring terminals 321 of the wiring member 32 have a plurality of pairs of two terminals, 231 and 321, which are electrically connected with each other via a signal wiring S'. At least one of the plurality of pairs has two terminals 231 and 321, the wiring length between which is maximum. The maximum wiring length is the length of a path between the two terminals 231 and 321 obtained when the terminals are viewed in the Z direction. That is, the length of a via is ignored in the maximum wiring length.

The maximum wiring length is shorter than the maximum length L2 of the sides 235 to 238 of the memory 23. The long side 235 (237) is longest in the plurality of sides 235 to 238. Thus, the maximum wiring length is shorter than the length L2 of the side 235 (237).

In addition, for reducing the difference between the wiring length, illustrated in FIG. 12A, between the signal terminal 2311 and the wiring terminal 3211, and the wiring length between the signal terminal 2312 and the wiring terminal 3212, it is preferable that a difference Dd' between a distance D5' between the signal terminal 2311 and the wiring terminal 3211, and a distance D6' between the signal terminal 2312 and the wiring terminal 3212 be made smaller as much as possible.

The distance D5' is a straight-line distance between the signal terminal 2311 and the wiring terminal 3211 obtained when the signal terminal 2111 and the wiring terminal 3111 are viewed in the Z direction. The distance D6' is a straight-line distance between the signal terminal 2312 and the wiring terminal 3212 obtained when the signal terminal 2312 and the wiring terminal 3212 are viewed in the Z direction. Thus, the difference Dd' is preferably smaller than the distance D4 between the signal terminal 2311 and the signal terminal 2312, and is more preferably smaller than the distance D3 between the wiring terminal 3211 and the wiring terminal 3212. That is, it is preferable that Dd' = |D5' - D6'| < D4, and it is more preferable that Dd' = |D5' - D6'| < D3.

In addition, the distances D5' and D6' may be larger than the distance D3, but are preferably made smaller as much as possible for reducing the delay of signals. That is, the distances D5' and D6' are preferably smaller than the distance D4. That is, it is preferable that D5' > D3 and D6' > D3, and that D5' < D4 and D6' < D4.

In addition, even if the distance D5' is the above-described maximum distance D0', it is preferable that Dd' = |D5' - D6'| < D4, and it is more preferable that Dd' = |D5' - D6'| < D3.

In addition, even if the distance D6' is the above-described maximum distance D0' or the second-longest distance between terminals, it is preferable that Dd' = |D5' - D6'| < D4, and it is more preferable that Dd' = |D5' - D6'| < D3.

Note that although the description has been made for the case where the distances D0', D5', and D6' are straight-line distances obtained when the distances are viewed in the Z direction, the distances D0', D5', and D6' may be distances in consideration of the thickness of the wiring board 13.

In the fourth embodiment, since the signal wiring S' can be made shorter, the transmission property of signals transmitted through the signal wiring S' can be improved. In this manner, the transmission speed of signals transmitted through the signal wiring S' can be increased. Thus, the fourth embodiment provides the technique advantageous for increasing the transmission speed of signals.

In the fourth embodiment, in the Z direction, the image processing engine 22 overlaps with the wiring board 13. Specifically, in the Z direction, one portion of the image processing engine 22 overlaps with the wiring board 13. That is, at least one portion of the image processing engine 22 is disposed in a space between the wiring board 13 and the wiring board 12. Thus, since the image processing engine 22 is disposed closer to the wiring member 32, the image processing module 100C is made smaller, and the wiring length of the signal wiring S' is made shorter. As a result, the transmission property of signals is further improved, and the transmission speed of signals can be made faster.

In addition, in the fourth embodiment, as illustrated in FIG. 12B, the plurality of terminals 220 of the image processing engine 22 includes signal terminals 221 that overlap with the wiring board 13 in the Z direction. That is, the plurality of signal terminals 221 of the image processing engine 22 includes at least one signal terminal 221 that overlaps with the wiring board 13. The signal terminal 221 that overlaps with the wiring board 13 is electrically connected to a corresponding one of the plurality of signal terminals 231 of the memory 23 illustrated in FIG. 13A, via the signal wiring S'. In the fourth embodiment, a signal terminal 221 included in the terminal group 226 is electrically connected to a corresponding one of the plurality of signal terminals 231 of the memory 23 via the signal wiring S'. In the image processing module 100C, the wiring length of the signal wiring S' is made shorter, and the transmission speed of signals can be made faster.

In the X direction, at least one of the signal terminals 221 included in the image processing engine 22 preferably overlaps with the memory 23. In the fourth embodiment, in the X direction, at least one of the signal terminals 221 included in the terminal group 226 preferably overlaps with the memory 23. In this manner, the signal wiring S' can be made shorter.

In addition, in the X direction, at least one of the plurality of capacitors 14 preferably overlaps with the wiring board 13. Furthermore, in the X direction, at least one of the plurality of capacitors 14 more preferably overlaps with the memory 23.

In the fourth embodiment, the description has been made for the case where the image processing module 100C includes the single memory 23 mounted on the wiring board 13. However, the present disclosure is not limited to this. For example, as in the second embodiment, the image processing module 100C may include two memories 23 mounted on the wiring board 13. In this case, one of the two memories 23 is one example of a fourth semiconductor device, and the other of the two memories 23 is one example of a fifth semiconductor device. The two memories 23 are electrically connected to the image processing engine 22 via the wiring member 32. In addition, the relationship in wiring between the two memories 23 and the image processing engine 22 via the wiring member 32 is almost the same as the relationship in wiring between the two memories 21 and the image processing engine 22 via the wiring member 31. Note that the two memories 23 may have the same configuration (type) as each other, or may have configurations (types) different from each other. For example, one of the two memories 23 may have a memory capacity of 1 GB, and the other of the two memories 23 may have a memory capacity of 2 GB. Like this, the two memories 23 may have configurations (types) different from each other.

In addition, each of the wiring members 31 and 32 of the fourth embodiment may be modified so as to have the configuration of the wiring member 31 of the modification of the first embodiment.

### Fifth Embodiment

Next, a fifth embodiment of the present disclosure will be described. In the following description, a component given an identical reference symbol of a component of the first, the second, the third, or the fourth embodiment has substantially the same configuration and effects as those of the component described in the first, the second, the third, or the fourth embodiment, unless otherwise specified, and features different from those of the first, the second, the third, and the fourth embodiments will be mainly described.

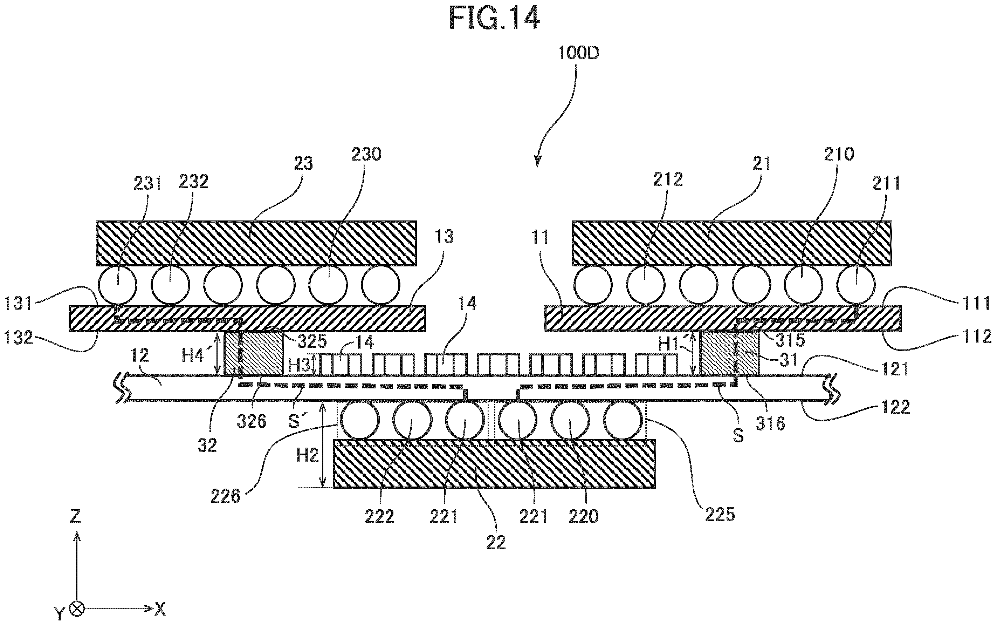

FIG. 14 is a diagram illustrating an image processing module 100D that is one example of an electronic module of the fifth embodiment. FIG. 14 schematically illustrates a cross section of the image processing module 100D, taken along an XZ plane.

In the fifth embodiment, in the camera 600 illustrated in FIG. 1, the image processing module 100D is used instead of the image processing module 100. The image processing module 100D of the fifth embodiment differs from the image processing module 100C of the fourth embodiment in the arrangement of the image processing engine 22 and the capacitors 14. That is, in the fifth embodiment, the image processing engine 22 is mounted on the main surface 122 of the wiring board 12, and the plurality of capacitors 14 is mounted on the main surface 121.

In the Z direction, the plurality of capacitors 14 overlaps with the image processing engine 22. In addition, in the Z direction, at least one portion of the image processing engine 22 and at least one of the plurality of capacitors 14 overlap with the wiring board 11. That is, at least one of the plurality of capacitors 14 is disposed in a space (area) between the wiring board 11 and the wiring board 12.

In addition, in the Z direction, at least one portion of the image processing engine 22 and at least one of the plurality of capacitors 14 overlap with the wiring board 13. That is, at least one of the plurality of capacitors 14 is disposed in a space (area) between the wiring board 13 and the wiring board 12.

The height H3 of the capacitors 14 in the Z direction is smaller than the height H2 of the image processing engine 22 in the Z direction. Thus, in the fifth embodiment, a distance H1' between the main surface 112 of the wiring board 11 and the main surface 121 of the wiring board 12 in the Z direction (that is, the height of the wiring member 31 in the Z direction) can be made smaller than the distance H1 illustrated in FIG. 2. In addition, in the fifth embodiment, a distance H4' between the main surface 132 of the wiring board 13 and the main surface 121 of the wiring board 12 in the Z direction (that is, the height of the wiring member 32 in the Z direction) can be made smaller than the distance H4 illustrated in FIG. 11. As a result, the fifth embodiment produces the same effects as those of the first and the fourth embodiments, and the image processing module 100D can be made smaller than the image processing module 100C of the fourth embodiment.

In the fifth embodiment, in the Z direction, at least one portion of the image processing engine 22 and at least one of the plurality of capacitors 14 overlap with the memory 21. In addition, in the Z direction, at least one portion of the image processing engine 22 and at least one of the plurality of capacitors 14 overlap with the memory 23. Thus, the image processing module 100D can be made smaller.

In the fifth embodiment, as in the fourth embodiment, the description has been made for the case where the image processing module 100D includes the single memory 23 mounted on the wiring board 13. However, the present disclosure is not limited to this. For example, as in the second embodiment, the image processing module 100D may include two memories 23 mounted on the wiring board 13.

Thus, the present disclosure provides the technique advantageous for increasing the transmission speed of signals.

### Other Modifications

The present disclosure is not limited to the above-described embodiments, and the embodiments can be variously modified within a technical concept of the present disclosure. For example, at least two of the plurality of above-described embodiments and the plurality of above-described modifications may be combined with each other. In addition, the effects described in the present embodiments are merely examples of the most suitable effects produced by the embodiments of the present disclosure. Thus, the effects of the embodiments of the present disclosure are not limited to the effects described in the present embodiments.

In the above-described embodiments, the description has been made for the case where the first semiconductor device is a memory and the second semiconductor device is an image processing engine. However, the present disclosure is not limited to this. The configurations of the above-described embodiments can be applied to any electronic module as long as signals are transmitted, in the electronic module, between the first semiconductor device and the second semiconductor device via the signal wiring. In addition, although the description has been made for the case where the third semiconductor device is a memory, the present disclosure is not limited to this. The configurations of the above-described embodiments can be applied to any electronic module as long as signals are transmitted, in the electronic module, between the third semiconductor device and the second semiconductor device via the signal wiring. For example, the electronic module may not be an image processing module, and may be an information processing module, a communication module, an image pickup module, a control module, or a display module. The semiconductor device mounted in the electronic module may be an image pickup device (image sensor), a display device (display), a memory device (memory), a communication device, a processing device (processor), a control device (controller), or a power supply device. At least two of the above-described devices can be appropriately combined with each other, and connected to each other via the wiring member.

In addition, the electronic apparatus to which the above-described embodiments can be applied may be an information apparatus, such as a smartphone or a personal computer, or may be a communication apparatus, such as a modem or a router. In another case, the electronic apparatus may be an office apparatus, such as a printer or a copying machine, a medical apparatus, such as an X-ray imaging apparatus or an endoscope, an industrial apparatus, such as a robot or a semiconductor manufacturing apparatus, or a transportation apparatus, such as a vehicle, an air plane, or a ship. In the electronic apparatus of the present embodiment, semiconductor devices can be mounted with high density, in a limited space in the exterior component. Thus, the present disclosure is useful for downsizing electronic apparatuses and improving the performance of the electronic apparatuses.

In addition, the disclosure of the present specification includes not only features described explicitly in the present specification, but also all features that can be understood from the present specification and the drawings attached to the present specification. In addition, the disclosure of the present specification includes the complement of each of the concepts described in the present specification. That is, if the present specification describes, for example, a feature in which Ais B, the present specification discloses a feature in which Ais not B, even if the present specification does not describe the feature in which A is not B. This is because if a feature in which A is B is described, the feature is described in consideration of the feature in which A is not B.

The disclosure of the embodiments described above include the following Items.
Item 1
   An electronic module including:
   a first wiring board;
   a first semiconductor device mounted on the first wiring board;
   a second wiring board configured to overlap with the first wiring board in a first direction orthogonal to a main surface of the first wiring board;
   a second semiconductor device mounted on the second wiring board; and
   a wiring member disposed between the first wiring board and the second wiring board and configured to connect the first wiring board and the second wiring board,
   wherein the wiring member includes a plurality of wiring terminals,
   wherein the first semiconductor device includes a plurality of signal terminals electrically connected to the second semiconductor device via the plurality of wiring terminals of the wiring member,
   wherein a first signal terminal of the plurality of signal terminals of the first semiconductor device is electrically connected to the second semiconductor device via a first wiring terminal of the plurality of wiring terminals of the wiring member,
   wherein a second signal terminal of the plurality of signal terminals of the first semiconductor device is electrically connected to the second semiconductor device via a second wiring terminal of the plurality of wiring terminals of the wiring member,
   wherein in the first direction, the first wiring terminal and the second wiring terminal are configured to overlap with the first semiconductor device, and
   wherein the first wiring terminal and the second wiring terminal are disposed between a first imaginary plane and a second imaginary plane, the first imaginary plane being orthogonal to the main surface and configured to cross the first signal terminal, the second imaginary plane being parallel to the first imaginary plane and configured to cross the second signal terminal.
Item 2
   An electronic module including:
   a first wiring board;
   a first semiconductor device mounted on the first wiring board;
   a second wiring board configured to overlap with the first wiring board in a first direction orthogonal to a main surface of the first wiring board;
   a second semiconductor device mounted on the second wiring board; and
   a wiring member disposed between the first wiring board and the second wiring board and configured to connect the first wiring board and the second wiring board,
   wherein the wiring member includes a plurality of wiring terminals,
   wherein the first semiconductor device includes a plurality of signal terminals electrically connected to the second semiconductor device via the plurality of wiring terminals of the wiring member,
   wherein a first signal terminal of the plurality of signal terminals of the first semiconductor device is electrically connected to the second semiconductor device via a first wiring terminal of the plurality of wiring terminals of the wiring member,
   wherein a second signal terminal of the plurality of signal terminals of the first semiconductor device is electrically connected to the second semiconductor device via a second wiring terminal of the plurality of wiring terminals of the wiring member,
   wherein in the first direction, the first wiring terminal and the second wiring terminal are configured to overlap with the first semiconductor device, and
   wherein the first signal terminal and the second signal terminal are configured not to overlap with the wiring member in the first direction.
Item 3
   The electronic module according to Item 1 or 2, wherein a distance between the first wiring terminal and the second wiring terminal is smaller than a distance between the first signal terminal and the second signal terminal.
Item 4
   The electronic module according to any one of Items 1 to 3, wherein a difference between a distance between the first signal terminal and the first wiring terminal and a distance between the second signal terminal and the second wiring terminal is smaller than a distance between the first wiring terminal and the second wiring terminal.
Item 5
   The electronic module according to any one of Items 1 to 4, wherein a difference between a distance between the first signal terminal and the first wiring terminal and a distance between the second signal terminal and the second wiring terminal is smaller than a distance between the first signal terminal and the second signal terminal.
Item 6
   The electronic module according to any one of Items 1 to 5, wherein each of a distance between the first signal terminal and the first wiring terminal and a distance between the second signal terminal and the second wiring terminal is smaller than a distance between the first signal terminal and the second signal terminal.
Item 7
   The electronic module according to any one of Items 1 to 6, wherein each of a distance between the first signal terminal and the first wiring terminal and a distance between the second signal terminal and the second wiring terminal is larger than a distance between the first wiring terminal and the second wiring terminal.
Item 8
   The electronic module according to Item 1, wherein the first signal terminal and the second signal terminal are configured not to overlap with the wiring member in the first direction.
Item 9
   The electronic module according to any one of Items 1 to 8, wherein the wiring member is separated from the first imaginary plane and the second imaginary plane, and disposed between the first imaginary plane and the second imaginary plane.
Item 10
   The electronic module according to any one of Items 1 to 9, wherein the plurality of signal terminals of the first semiconductor device and the plurality of wiring terminals of the wiring member include a plurality of pairs of two terminals electrically connected to each other,
   wherein at least one of the plurality of pairs has the two terminals, a distance between which is maximum, and
   wherein the maximum distance is shorter than a maximum length of sides of the first semiconductor device.
Item 11
   The electronic module according to any one of Items 1 to 10, wherein the plurality of signal terminals of the first semiconductor device and the plurality of wiring terminals of the wiring member include a plurality of pairs of two terminals electrically connected to each other,
   wherein at least one of the plurality of pairs has the two terminals, a wiring length between which is maximum, and
   wherein the maximum wiring length is shorter than a maximum length of sides of the first semiconductor device.
Item 12
   An electronic module including:
   a first wiring board;
   a first semiconductor device mounted on the first wiring board;
   a second wiring board configured to overlap with the first wiring board in a first direction orthogonal to a main surface of the first wiring board;
   a second semiconductor device mounted on the second wiring board;
   a third semiconductor device mounted on the first wiring board; and
   a wiring member disposed between the first wiring board and the second wiring board and configured to connect the first wiring board and the second wiring board,
   wherein the wiring member includes a first portion and a second portion, the first portion being positioned between the first semiconductor device and the second wiring board in the first direction, the second portion being positioned between the third semiconductor device and the second wiring board in the first direction, and
   wherein the first semiconductor device is electrically connected to the second semiconductor device via the first portion and the third semiconductor device is electrically connected to the second semiconductor device via the second portion.
Item 13
   The electronic module according to any one of Items 1 to 12, wherein the wiring member is configured to overlap with a center of the first semiconductor device in the first direction.
Item 14
   The electronic module according to any one of Items 1 to 13, wherein the second semiconductor device is configured to overlap with the first wiring board in the first direction.
Item 15
   The electronic module according to any one of Items 1 to 14, wherein the second semiconductor device includes a signal terminal configured to overlap with the first wiring board in the first direction, and
   wherein the signal terminal of the second semiconductor device is electrically connected to any of the plurality of signal terminals of the first semiconductor device.
Item 16
   The electronic module according to Item 15, wherein the signal terminal of the second semiconductor device is configured to overlap with the first semiconductor device in the first direction.
Item 17
   The electronic module according to any one of Items 1 to 16, wherein the main surface of the first wiring board is a first main surface,
   wherein the first semiconductor device is mounted on the first main surface of the first wiring board, and
   wherein the wiring member is joined to a second main surface of the first wiring board opposite to the first main surface, and is joined to a third main surface of the second wiring board.
Item 18
   The electronic module according to Item 17, wherein the second semiconductor device is mounted on the third main surface of the second wiring board.
Item 19
   The electronic module according to Item 18, further including:
   a capacitor mounted on a fourth main surface of the second wiring board opposite to the third main surface.
Item 20
   The electronic module according to Item 19, wherein the capacitor is configured to overlap with the second semiconductor device in the first direction.
Item 21
   The electronic module according to any one of Items 17 to 20, wherein the second semiconductor device is mounted on a fourth main surface of the second wiring board opposite to the third main surface.
Item 22
   The electronic module according to Item 21, further including:
   a capacitor mounted on the third main surface of the second wiring board.
Item 23
   The electronic module according to Item 22, wherein the capacitor is configured to overlap with at least any one of the second semiconductor device, the first wiring board, and the first semiconductor device.
Item 24
   The electronic module according to any one of Items 1 to 11, further including:
   a third semiconductor device mounted on the first wiring board,
   wherein the third semiconductor device is electrically connected to the second semiconductor device via the wiring member.
Item 25
   The electronic module according to any one of Items 1 to 24, wherein the first semiconductor device is a memory device, and
   wherein the second semiconductor device is a processing device.
Item 26
   The electronic module according to Item 1, wherein the wiring member is a first wiring member,
   wherein the electronic module includes
      a third wiring board configured to overlap with the second wiring board in the first direction,
      a fourth semiconductor device mounted on the third wiring board, and
      a second wiring member disposed between the third wiring board and the second wiring board and configured to connect the third wiring board and the second wiring board,
   wherein the second wiring member includes a plurality of wiring terminals,
   wherein the fourth semiconductor device includes a plurality of signal terminals electrically connected to the second semiconductor device via the plurality of wiring terminals of the second wiring member,
   wherein a third signal terminal of the plurality of signal terminals of the fourth semiconductor device is electrically connected to the second semiconductor device via a third wiring terminal of the plurality of wiring terminals of the second wiring member,
   wherein a fourth signal terminal of the plurality of signal terminals of the fourth semiconductor device is electrically connected to the second semiconductor device via a fourth wiring terminal of the plurality of wiring terminals of the second wiring member,
   wherein in the first direction, the third wiring terminal and the fourth wiring terminal are configured to overlap with the fourth semiconductor device, and
   wherein the third wiring terminal and the fourth wiring terminal are disposed between a third imaginary plane and a fourth imaginary plane, the third imaginary plane being orthogonal to the main surface and configured to cross the third signal terminal, the fourth imaginary plane being parallel to the third imaginary plane and configured to cross the fourth signal terminal.
Item 27
   The electronic module according to Item 2, wherein the wiring member is a first wiring member,
   wherein the electronic module includes
      a third wiring board configured to overlap with the second wiring board in the first direction,
      a fourth semiconductor device mounted on the third wiring board, and
      a second wiring member disposed between the third wiring board and the second wiring board and configured to connect the third wiring board and the second wiring board,
   wherein the second wiring member includes a plurality of wiring terminals,
   wherein the fourth semiconductor device includes a plurality of signal terminals electrically connected to the second semiconductor device via the plurality of wiring terminals of the second wiring member,
   wherein a third signal terminal of the plurality of signal terminals of the fourth semiconductor device is electrically connected to the second semiconductor device via a third wiring terminal of the plurality of wiring terminals of the second wiring member,
   wherein a fourth signal terminal of the plurality of signal terminals of the fourth semiconductor device is electrically connected to the second semiconductor device via a fourth wiring terminal of the plurality of wiring terminals of the second wiring member,
   wherein in the first direction, the third wiring terminal and the fourth wiring terminal are configured to overlap with the fourth semiconductor device, and
   wherein the third signal terminal and the fourth signal terminal are configured not to overlap with the second wiring member in the first direction.
Item 28
   The electronic module according to Item 12, wherein the wiring member is a first wiring member,
   wherein the electronic module includes
      a third wiring board configured to overlap with the second wiring board in the first direction,
      a fourth semiconductor device mounted on the third wiring board, and
      a second wiring member disposed between the third wiring board and the second wiring board and configured to connect the third wiring board and the second wiring board, and
   wherein the fourth semiconductor device is electrically connected to the second semiconductor device via the second wiring member.
Item 29
   The electronic module according to Item 28, further including:
   a fifth semiconductor device mounted on the third wiring board,
   wherein the fifth semiconductor device is electrically connected to the second semiconductor device via the second wiring member.
Item 30
   An electronic apparatus including:
   an exterior; and
   the electronic module according to any one of Items 1 to 29 and disposed inside the exterior.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An electronic module (100, 100A, 100B, 100C, 100D) comprising:
a first wiring board (11);
a first semiconductor device (21) mounted on the first wiring board (11);
a second wiring board (12) configured to overlap with the first wiring board (11) in a first direction (Z) orthogonal to a main surface (111) of the first wiring board (11);
a second semiconductor device (22) mounted on the second wiring board (12); and
a wiring member (31) disposed between the first wiring board (11) and the second wiring board (12) and configured to connect the first wiring board (11) and the second wiring board (12),
wherein the wiring member (31) includes a plurality of wiring terminals (311),
wherein the first semiconductor device (21) includes a plurality of signal terminals (211) electrically connected to the second semiconductor device (22) via the plurality of wiring terminals (311) of the wiring member (31),
wherein a first signal terminal (2111) of the plurality of signal terminals (211) of the first semiconductor device (21) is electrically connected to the second semiconductor device (22) via a first wiring terminal (3111) of the plurality of wiring terminals (311) of the wiring member (31),
wherein a second signal terminal (2112) of the plurality of signal terminals (211) of the first semiconductor device (21) is electrically connected to the second semiconductor device (22) via a second wiring terminal (3112) of the plurality of wiring terminals (311) of the wiring member (31),
wherein in the first direction (Z), the first wiring terminal (3111) and the second wiring terminal (3112) are configured to overlap with the first semiconductor device (21), and
wherein the first wiring terminal (3111) and the second wiring terminal (3112) are disposed between a first imaginary plane (V1) and a second imaginary plane (V2), the first imaginary plane (V1) being orthogonal to the main surface (111) and configured to cross the first signal terminal (2111), the second imaginary plane (V2) being parallel to the first imaginary plane (V1) and configured to cross the second signal terminal (2112), and/or the first signal terminal (2111) and the second signal terminal (2112) are configured not to overlap with the wiring member (31) in the first direction (Z).

2. The electronic module (100, 100A, 100B, 100C, 100D) according to claim 1, wherein a distance (D1) between the first wiring terminal (3111) and the second wiring terminal (3112) is smaller than a distance (D2) between the first signal terminal (2111) and the second signal terminal (2112).

3. The electronic module (100, 100A, 100B, 100C, 100D) according to claim 1 or 2, wherein a difference (Dd) between a distance (D5) between the first signal terminal (2111) and the first wiring terminal (3111) and a distance (D6) between the second signal terminal (2112) and the second wiring terminal (3112) is smaller than a distance (D1) between the first wiring terminal (3111) and the second wiring terminal (3112), and/or the difference (Dd) between the distance (D5) between the first signal terminal (2111) and the first wiring terminal (3111) and the distance (D6) between the second signal terminal (2112) and the second wiring terminal (3112) is smaller than a distance (D2) between the first signal terminal (2111) and the second signal terminal (2112).

4. The electronic module (100, 100A, 100B, 100C, 100D) according to any one of claims 1 to 3, wherein each of a distance (D5) between the first signal terminal (2111) and the first wiring terminal (3111) and a distance (D6) between the second signal terminal (2112) and the second wiring terminal (3112) is smaller than a distance (D2) between the first signal terminal (2111) and the second signal terminal (2112), and/or each of the distance (D5) between the first signal terminal (2111) and the first wiring terminal (3111) and the distance (D6) between the second signal terminal (2112) and the second wiring terminal (3112) is larger than a distance (D1) between the first wiring terminal (3111) and the second wiring terminal (3112).

5. The electronic module (100, 100A, 100B, 100C, 100D) according to any one of claims 1 to 4, wherein the first signal terminal (2111) and the second signal terminal (2112) are configured not to overlap with the wiring member (31) in the first direction (Z).

6. The electronic module (100, 100A, 100B, 100C, 100D) according to any one of claims 1 to 5, wherein the wiring member (31) is separated from the first imaginary plane (V1) and the second imaginary plane (V2), and disposed between the first imaginary plane (V1) and the second imaginary plane (V2).

7. The electronic module (100, 100A, 100B, 100C, 100D) according to any one of claims 1 to 6, wherein the plurality of signal terminals (211) of the first semiconductor device (21) and the plurality of wiring terminals (311) of the wiring member (31) include a plurality of pairs of two terminals electrically connected to each other, and
wherein at least one of the plurality of pairs has the two terminals, a distance (D0) between which is maximum, the maximum distance (D0) being shorter than a maximum length (L1) of sides of the first semiconductor device (21), and/or at least one of the plurality of pairs has the two terminals, a wiring length (L0) between which is maximum, the maximum wiring length (L0) being shorter than a maximum length (L1) of sides of the first semiconductor device (21).

8. The electronic module (100A, 100B, 100C, 100D) according to any one of claims 1 to 7, further comprising:
a third semiconductor device (21) mounted on the first wiring board (11),
wherein the third semiconductor device (21) is electrically connected to the second semiconductor device (22) via the wiring member (31).

9. The electronic module (100C, 100D) according to any one of claims 1 to 8, wherein the wiring member (31) is a first wiring member (31),
wherein the electronic module (100C, 100D) includes
a third wiring board (13) configured to overlap with the second wiring board (12) in the first direction (Z),
a fourth semiconductor device (23) mounted on the third wiring board (13), and
a second wiring member (32) disposed between the third wiring board (13) and the second wiring board (12) and configured to connect the third wiring board (13) and the second wiring board (12),
wherein the second wiring member (32) includes a plurality of wiring terminals (321),
wherein the fourth semiconductor device (23) includes a plurality of signal terminals (231) electrically connected to the second semiconductor device (22) via the plurality of wiring terminals (321) of the second wiring member (32),
wherein a third signal terminal (2311) of the plurality of signal terminals (231) of the fourth semiconductor device (23) is electrically connected to the second semiconductor device (22) via a third wiring terminal (3211) of the plurality of wiring terminals (321) of the second wiring member (32),
wherein a fourth signal terminal (2312) of the plurality of signal terminals (231) of the fourth semiconductor device (23) is electrically connected to the second semiconductor device (22) via a fourth wiring terminal (3212) of the plurality of wiring terminals (321) of the second wiring member (32),
wherein in the first direction (Z), the third wiring terminal (3211) and the fourth wiring terminal (3212) are configured to overlap with the fourth semiconductor device (23), and
wherein the third wiring terminal (3211) and the fourth wiring terminal (3212) are disposed between a third imaginary plane (V3) and a fourth imaginary plane (V4), the third imaginary plane (V3) being orthogonal to the main surface (111) and configured to cross the third signal terminal (2311), the fourth imaginary plane (V4) being parallel to the third imaginary plane (V3) and configured to cross the fourth signal terminal (2312), and/or the third signal terminal (2311) and the fourth signal terminal (2312) are configured not to overlap with the second wiring member (32) in the first direction (Z).

10. The electronic module (100, 100A, 100B, 100C,100D) according to any one of claims 1 to 9, wherein the wiring member (31) is configured to overlap with a center of the first semiconductor device (21) in the first direction (Z), and/or the second semiconductor device (22) is configured to overlap with the first wiring board (11) in the first direction (Z).

11. The electronic module (100, 100A, 100B, 100C, 100D) according to any one of claims 1 to 10, wherein the second semiconductor device (22) includes a signal terminal (221) configured to overlap with the first wiring board (11) in the first direction (Z), and
wherein the signal terminal (221) of the second semiconductor device (22) is electrically connected to any of the plurality of signal terminals (211) of the first semiconductor device (21), and/or the signal terminal (221) of the second semiconductor device (22) is configured to overlap with the first semiconductor device (21) in the first direction (Z).

12. The electronic module (100, 100A, 100B, 100C, 100D) according to any one of claims 1 to 11, wherein the main surface (111) of the first wiring board (11) is a first main surface (111),
wherein the first semiconductor device (21) is mounted on the first main surface (111) of the first wiring board (11), and
wherein the wiring member (31) is joined to a second main surface (112) of the first wiring board (11) opposite to the first main surface (111), and is joined to a third main surface (121) of the second wiring board (12).

13. The electronic module (100, 100A, 100C) according to claim 12, wherein the second semiconductor device (22) is mounted on the third main surface (121) of the second wiring board (12), or the second semiconductor device (22) is mounted on a fourth main surface (122) of the second wiring board (12) opposite to the third main surface (121).

14. The electronic module (100, 100A, 100C) according to according to claim 12 or 13, further comprising:
a plurality of capacitors (14) mounted on the second wiring board (12), the plurality of capacitors including a first capacitor and/or a second capacitor,
wherein the first capacitor (14) is mounted on a fourth main surface (122) of the second wiring board (12) opposite to the third main surface (121), and/or, the first capacitor (14) is configured to overlap with the second semiconductor device (22) in the first direction (Z), and/or the second capacitor (14) is mounted on the third main surface (121) of the second wiring board (12), and/or the second capacitor (14) is configured to overlap with at least any one of the second semiconductor device (22), the first wiring board (11), and the first semiconductor device (21).

15. The electronic module (100, 100A, 100B, 100C, 100D) according to any one of claims 1 to 14, wherein the first semiconductor device (21) is a memory device, and
wherein the second semiconductor device (22) is a processing device.

16. An electronic apparatus comprising:
an exterior (611); and
the electronic module (100, 100A, 100B, 100C, 100D) according to any one of claims 1 to 15 and disposed inside the exterior (611).
